# EUROPEAN PATENT SPECIFICATION

(11) **EP 4 571 947 B1**
(45) Date of publication and mention of the grant of the patent: **01.04.2026**
(21) Application number: 24208016.6
(22) Date of filing: 22.10.2024
(51) Int. Cl.: H01M 10/6569, H01M 10/613, H01M 10/633, H01M 10/6568, H01M 10/627

(54) **BATTERY HEAT-DISSIPATION PROCESSING METHOD, ELECTRONIC DEVICE, AND STORAGE MEDIUM**
VERFAHREN ZUR WARMEABLEITUNG VON BATTERIEN, ELEKTRONISCHE VORRICHTUNG UND SPEICHERMEDIUM
PROCÉDÉ DE TRAITEMENT DE DISSIPATION DE CHALEUR DE BATTERIE, DISPOSITIF ÉLECTRONIQUE ET SUPPORT DE STOCKAGE

(30) Priority: 30.10.2023 CN 202311423236
(43) Date of publication of application: 18.06.2025
(73) Proprietor: Hithium Tech HK Limited, Hong Kong (HK)
(72) Inventor: MA, Yaqiang, Xiamen, 361100 (CN)
(74) Representative: Santarelli

(56) References cited:
- CN-A- 116 799 369

## Description

### TECHNICAL FIELD

This disclosure relates to the field of energy-storage heat-dissipation technology, and in particular, to a battery heat-dissipation processing method, an electronic device, and a storage medium.

### BACKGROUND

In consideration of energy safety, electric energy substitution, and peak cut, an electrochemical energy-storage power station is increased in scale, and an energy-storage battery system has a large battery capacity and power. Since a high power density has a high demand for heat dissipation and problems such as battery heat generation and uneven temperature distribution easily occur inside the energy-storage system, temperature control is very important for the service life and safety of a battery.

At present, liquid cooling technologies (including single-phase immersion, two-phase immersion, and cold plate) are generally used for battery heat dissipation, and the liquid cooling technologies can satisfy the high-power heat-dissipation demand of the battery for high-rate charging and discharging for a long time. In particular, immersion liquid cooling technologies can allow energy-storage batteries to be immersed in liquid, so that the temperature of the batteries decreases uniformly, which can better prevent thermal runaway and thermal spread and ensure the higher fire safety. However, during immersion liquid cooling, the efficiency of condensation and recovery of phase-changed gas is relatively low, and thus the heat-dissipation effect of the battery is reduced. Therefore, the problem of how to improve the heat-dissipation effect of the battery needs to be solved urgently.
CN116799369A provides a battery immersion heat safety management experiment device and method with a condensation recovery function. The battery immersion heat safety management experiment device comprises a three-way heat exchanger, a first heat exchanger, a liquid storage/supplement tank, a double-flow-channel heat exchanger, a temperature sensor and a liquid level sensor. Whether circulating condensation needs to be started or not can be controlled according to the temperature of a cooling working medium and the height of the liquid level to enhance the heat dissipation capacity, the battery module is immersed in cooling liquid all the time, and heat generated in the charging and discharging process of the battery module is effectively taken away.

### SUMMARY

Aspects of the invention are set out in the appended claims. In a first aspect, a battery heat-dissipation processing method is provided in embodiments of the disclosure. The method is applied to a liquid cooling system. The liquid cooling system includes a liquid cooling apparatus, an air pump, a box body, a condenser pipe, and a cooling apparatus. The box body includes P battery packs, where P is a positive integer. The condenser pipe is disposed above the box body. Each of the P battery packs has one liquid outlet and one liquid inlet, and the one liquid outlet and the one liquid inlet are both connected to the condenser pipe. The one liquid inlet corresponds to one liquid-inlet solenoid valve, and the one liquid outlet corresponds to one liquid-outlet solenoid valve. The one liquid outlet is connected to the condenser pipe and the liquid cooling apparatus. The one liquid inlet is connected to the liquid cooling apparatus through the air pump. The cooling apparatus is connected to the liquid cooling apparatus. The liquid cooling apparatus is configured to store a first cooling liquid. The cooling apparatus is configured to store a second cooling liquid. The method includes the following. When a temperature of battery pack *a* is greater than a first temperature threshold, a target difference between the temperature and the first temperature threshold is determined, an opening parameter of a target liquid-inlet solenoid valve of battery pack *a* is determined according to the target difference, and the target liquid-inlet solenoid valve of battery pack *a* is opened according to the opening parameter. Battery pack *a* is any one of the *P* battery packs. The target liquid-inlet solenoid valve is a liquid-inlet solenoid valve corresponding to a liquid inlet of battery pack *a.* The liquid cooling apparatus is controlled to deliver to battery pack *a* the first cooling liquid through the air pump via a target liquid inlet of battery pack *a* to immerse battery pack *a,* where the target liquid inlet is the liquid inlet of battery pack *a.* The target liquid-inlet solenoid valve is closed when an immersion degree of battery pack *a* exceeds a preset degree. The first cooling liquid is cycled through the condenser pipe to dissipate heat for battery pack *a* with the first cooling liquid, where the first cooling liquid changes from a liquid state into a gaseous state after heat absorption, a gaseous cooling liquid enters the condenser pipe, and the gaseous cooling liquid changes into the liquid state through heat dissipation in the condenser pipe and falls back into battery pack *a* to form a condensing loop. When a current heat-dissipation rate of battery pack *a* is lower than a preset heat-dissipation rate, a target heat-dissipation rate difference between the preset heat-dissipation rate and the current heat-dissipation rate is determined, a target discharge rate of the first cooling liquid is determined according to the target heat-dissipation rate difference, and the first cooling liquid in battery pack *a* is discharged into the liquid cooling apparatus through a target liquid outlet of battery pack *a* according to the target discharge rate, where target liquid outlet is a liquid outlet of battery pack *a.* The liquid cooling apparatus is controlled to perform heat conduction between the first cooling liquid in the liquid cooling apparatus and the second cooling liquid in the cooling apparatus to implement heat dissipation of the first cooling liquid, and the first cooling liquid that is subject to heat dissipation is delivered to battery pack *a* through the target liquid inlet of battery pack *a* to dissipate heat for battery pack *a.* When the temperature of battery pack *a* is lower than a second temperature threshold, a target liquid-outlet solenoid valve of battery pack *a* is opened according to an operation situation of the condensing loop and the target liquid-inlet solenoid valve of battery pack *a* is opened according to an operation situation of the heat conduction, and then the first cooling liquid in battery pack *a* is discharged from battery pack *a* through the air pump, where the first temperature threshold is greater than the second temperature threshold. The target liquid-outlet solenoid valve is a liquid-outlet solenoid valve corresponding to the target liquid outlet of battery pack *a.*

In a second aspect, a battery heat-dissipation processing apparatus is provided in embodiments of the disclosure. The apparatus is applied to a liquid cooling system. The liquid cooling system includes a liquid cooling apparatus, an air pump, a box body, a condenser pipe, and a cooling apparatus. The box body includes *P* battery packs, where *P* is a positive integer. The condenser pipe is disposed above the box body. Each of the *P* battery packs has one liquid outlet and one liquid inlet, and the one liquid outlet and the one liquid inlet are both connected to the condenser pipe. The one liquid inlet corresponds to one liquid-inlet solenoid valve, and the one liquid outlet corresponds to one liquid-outlet solenoid valve. The one liquid outlet is connected to the condenser pipe and the liquid cooling apparatus. The one liquid inlet is connected to the liquid cooling apparatus through the air pump. The cooling apparatus is connected to the liquid cooling apparatus. The liquid cooling apparatus is configured to store a first cooling liquid. The cooling apparatus is configured to store a second cooling liquid. The battery heat-dissipation processing apparatus includes an operating unit, a control unit, and a condensing unit. The operating unit is configured to determine a target difference between a temperature of battery pack *a* and a first temperature threshold, determine an opening parameter of a target liquid-inlet solenoid valve of battery pack *a* according to the target difference, and open the target liquid-inlet solenoid valve of battery pack *a* according to the opening parameter when the temperature is greater than the first temperature threshold, where battery pack *a* is any one of the *P* battery packs, and the target liquid-inlet solenoid valve is a liquid-inlet solenoid valve corresponding to a liquid inlet of battery pack *a.* The control unit is configured to control the liquid cooling apparatus to deliver to battery pack *a* the first cooling liquid through the air pump via a target liquid inlet of battery pack *a* to immerse battery pack *a,* and close the target liquid-inlet solenoid valve when an immersion degree of battery pack *a* exceeds a preset degree, where the target liquid inlet is the liquid inlet of battery pack *a.* The condensing unit is configured to cycle the first cooling liquid through the condenser pipe to dissipate heat for battery pack *a* with the first cooling liquid, where the first cooling liquid changes from a liquid state into a gaseous state after heat absorption, a gaseous cooling liquid enters the condenser pipe, and the gaseous cooling liquid changes into the liquid state through heat dissipation in the condenser pipe and falls back into battery pack *a* to form a condensing loop. The control unit is further configured to determine a target heat-dissipation rate difference between a preset heat-dissipation rate and a current heat-dissipation rate of battery pack *a,* determine a target discharge rate of the first cooling liquid according to the target heat-dissipation rate difference, and discharge the first cooling liquid in battery pack *a* into the liquid cooling apparatus through a target liquid outlet of battery pack *a* according to the target discharge rate when the current heat-dissipation rate is lower than the preset heat-dissipation rate, where the target liquid outlet is a liquid outlet of battery pack *a.* The control unit is further configured to control the liquid cooling apparatus to perform heat conduction between the first cooling liquid in the liquid cooling apparatus and the second cooling liquid in the cooling apparatus to implement heat dissipation of the first cooling liquid, and deliver, through the target liquid inlet of battery pack *a,* the first cooling liquid that is subject to heat dissipation to battery pack *a* to dissipate heat for battery pack *a.* The operating unit is further configured to open a target liquid-outlet solenoid valve of battery pack *a* according to an operation situation of the condensing loop and the target liquid-inlet solenoid valve of battery pack *a* according to an operation situation of the heat conduction, and then discharge from battery pack *a* the first cooling liquid in battery pack *a* through the air pump when the temperature of battery pack *a* is lower than a second temperature threshold, where the first temperature threshold is greater than the second temperature threshold, and the target liquid-outlet solenoid valve is a liquid-outlet solenoid valve corresponding to the target liquid outlet of battery pack *a.*

In a third aspect, an electronic device is provided in embodiments of the disclosure. The electronic device includes a processor, a memory, a communication interface, and one or more programs. The one or more programs are stored in the memory and configured to be executed by the processor, where the programs contain instructions for executing operations described in the first aspect of embodiments of the disclosure.

In a fourth aspect, a computer-readable storage medium is provided in embodiments of the disclosure. The computer-readable storage medium is configured to store a computer program for electronic data interchange (EDI), where the computer program causes a computer to execute part or all of operations described in the first aspect of embodiments of the disclosure.

### BRIEF DESCRIPTION OF THE DRAWINGS

To describe embodiments of the disclosure or technical solutions in related art more clearly, the following will give a brief introduction to the accompanying drawings used for describing the embodiments or the related art. Apparently, the accompanying drawings described below are merely some embodiments of the disclosure. Based on these drawings, those of ordinary skill in the art can also obtain other drawings without creative effort.
FIG. 1 is a schematic structural view of a liquid cooling system provided in embodiments of the disclosure.
FIG. 2 is a schematic structural view of a liquid cooling system provided in other embodiments of the disclosure.
FIG. 3 is a schematic flowchart of a battery heat-dissipation processing method provided in embodiments of the disclosure.
FIG. 4 is a schematic flowchart of a battery heat-dissipation processing method provided in other embodiments of the disclosure.
FIG. 5 is a schematic flowchart of a battery heat-dissipation processing method provided in other embodiments of the disclosure.
FIG. 6 is a schematic flowchart of a battery heat-dissipation processing method provided in other embodiments of the disclosure.
FIG. 7 is a schematic structural view of an electronic device provided in embodiments of the disclosure.
FIG. 8 is a block diagram of functional units of a battery heat-dissipation processing apparatus provided in embodiments of the disclosure.

### DETAILED DESCRIPTION

To enable those skilled in the art to better understand the solutions of the present disclosure, the technical solutions in embodiments of the disclosure will be clearly and completely described below in conjunction with the accompanying drawings in the embodiments of the disclosure. Apparently, the described embodiments are merely some of, rather than all, the embodiments of the disclosure. All other embodiments obtained by those of ordinary skill in the art based on the embodiments of the disclosure without any creative effort shall fall within the scope of protection of the disclosure.

The terms such as "first" and "second" in the specification and the claims of the disclosure and in the accompanying drawings are intended to distinguish different objects, rather than to describe a specific order. In addition, the terms of "include" and "have" and any variations thereof are intended to cover the non-exclusive inclusion. For example, the process, method, system, product, or device, which includes a series of steps or units, is not limited to the listed steps or units, but optionally further includes unlisted steps or units, or optionally further includes other steps or units inherent to the process, method, product, or device.

The terms of "embodiment" mentioned herein means that the specific features, structures, or characteristics described with reference to the embodiments may be encompassed in at least one embodiment of the disclosure. The phrase at various locations in the specification does not necessarily refer to the same embodiment, or an independent or alternative embodiment exclusive of another embodiment. Those skilled in the art may understand explicitly and implicitly that the embodiments described herein may be combined with other embodiments.

The following will describe embodiments of the disclosure in detail.

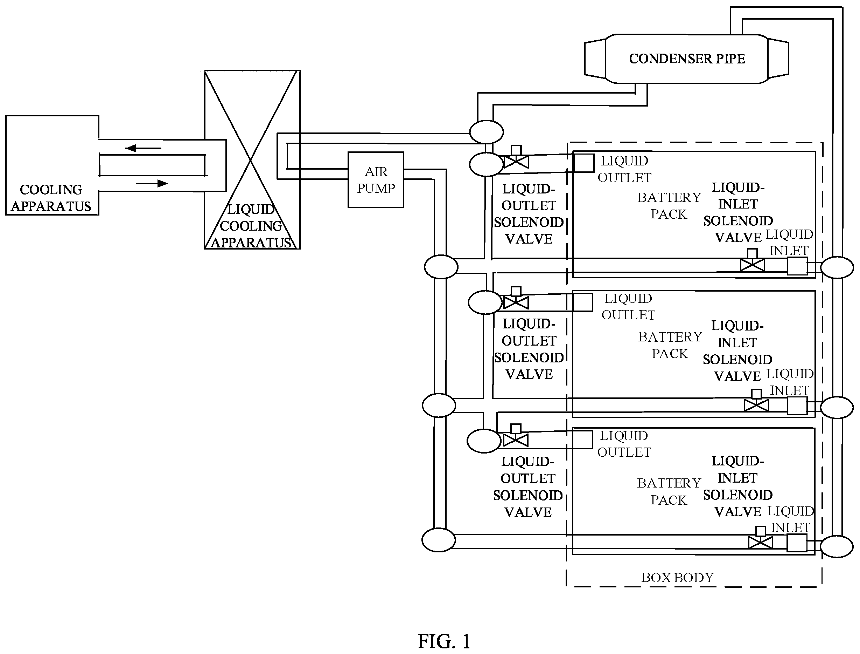

Reference is made to FIG. 1, where FIG. 1 is a schematic structural view of a liquid cooling system provided in embodiments of the disclosure. As illustrated in FIG. 1, the liquid cooling system includes a liquid cooling apparatus, an air pump, a box body, a condenser pipe, and a cooling apparatus. The box body includes *P* battery packs, where *P* is a positive integer. The condenser pipe is disposed above the box body. Each of the *P* battery packs has one liquid outlet and one liquid inlet, and the one liquid outlet and the one liquid inlet are both connected to the condenser pipe. The one liquid inlet corresponds to one liquid-inlet solenoid valve, and the one liquid outlet corresponds to one liquid-outlet solenoid valve. The one liquid outlet is connected to the condenser pipe and the liquid cooling apparatus. The one liquid inlet is connected to the liquid cooling apparatus through the air pump. The cooling apparatus is connected to the liquid cooling apparatus. The liquid cooling apparatus is configured to store a first cooling liquid. The cooling apparatus is configured to store a second cooling liquid.

In embodiments, as illustrated in FIG. 1, an "ellipse" in the figure represents a valve, and the valve may be a three-port valve.

During implementation, the box body is a structure for accommodating a battery. The box body is generally made of a high-strength material such as steel or aluminum alloy, and has a function of protection, so as to protect the battery from being damaged or influenced by an external environment.

The air pump may be a two-way air pump. The cooling device may be a cooling tower. Each of the *P* battery packs has a liquid inlet and a liquid outlet, and a location of the liquid outlet in the battery pack is higher than a location of the liquid inlet.

In embodiments, the first cooling liquid may include one or more of fluorinated liquid, ethylene glycol, propylene glycol, or glycerol, which is not limited herein. The second cooling liquid may include one or more of water or brine. The condenser pipe contains a coolant, and the coolant may include one or more of water or alcohol.

Optionally, the bottom of the box body may have multiple protrusion structures. The multiple protrusion structures may be positioned at intervals on the bottom of the box body and may be each connected to two opposite side walls of the box body. A top end of each of the protrusion structures is hollowed out. The multiple protrusion structures define, on the bottom of the multiple protrusion structures, flow channels for the first cooling liquid to flow through.

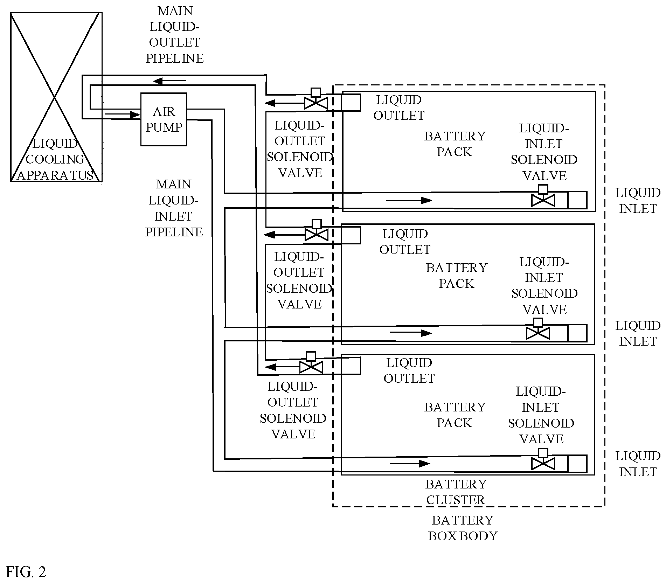

Reference is made to FIG. 2, where FIG. 2 is a schematic structural view of a liquid cooling system provided in other embodiments of the disclosure. The liquid cooling system illustrated in FIG. 2 includes a battery box body, a battery cluster, an air pump, and a liquid cooling apparatus. The battery cluster is located inside the battery box body. The battery cluster includes *P* battery packs, each of the *P* battery packs has a liquid inlet and a liquid outlet, the liquid inlet corresponds to one liquid-inlet solenoid valve, and the liquid outlet corresponds to one liquid-outlet solenoid valve, where *P* is a positive integer. The liquid cooling apparatus contains a liquid cooling medium. The liquid cooling apparatus is connected to the liquid inlet of each battery pack in the battery cluster through the air pump. The liquid cooling apparatus is connected to the liquid outlet of each battery pack in the battery cluster.

During implementation, the battery box body is a structure for accommodating a battery. The battery box body is generally made of a high-strength material such as steel or aluminum alloy, and has a function of protection, so as to protect the battery from being damaged or influenced by an external environment. The liquid cooling apparatus is connected to the battery cluster through a main liquid-inlet pipeline and a main liquid-outlet pipeline, and each battery pack in the battery cluster is connected to the liquid cooling apparatus through a branch pipeline of the main liquid-inlet pipeline and a branch pipeline of the main liquid-outlet pipeline.

In embodiments, the air pump is installed at the main liquid-inlet pipeline, and the air pump may be a two-way air pump. Each battery pack in the battery cluster has a liquid inlet and a liquid outlet, and a location of the liquid outlet is higher than a location of the liquid inlet. The liquid cooling medium in the liquid cooling apparatus may include one or more of fluorinated liquid, ethylene glycol, propylene glycol, or glycerol, which is not limited herein.

Optionally, the bottom of the battery box body may have multiple protrusion structures that are positioned at intervals on the bottom of the box body and are each connected to two opposite side walls of the box body. A top end of each of the protrusion structures is hollowed out. The multiple protrusion structures define, on the bottom of the multiple protrusion structures, flow channels for the liquid cooling medium to flow through.

Compared with the liquid cooling system illustrated in FIG. 1, the liquid cooling system illustrated in FIG. 2 differs in that the cooling apparatus and the condenser pipe are omitted. In addition, since the condenser pipe is omitted, a valve used by the liquid cooling system illustrated in FIG. 2 may be a conventional solenoid valve.

Based on the liquid cooling system illustrated in FIG. 2, the following functions can be realized. An average temperature of battery pack *k* within a preset time period is obtained, where battery pack *k* is any one of the *P* battery packs. When the average temperature is higher than a first temperature, a temperature change of battery pack *k* is determined, and a target liquid-inlet solenoid valve of battery pack *k* is opened according to the temperature change, where the target liquid-inlet solenoid valve is a liquid-inlet solenoid valve corresponding to a liquid inlet of battery pack *k.* The liquid cooling apparatus is controlled to deliver to battery pack *k* the liquid cooling medium through a liquid inlet of battery pack *k* to immerse battery pack *k.* When an immersion degree of battery pack *k* reaches a set degree, an internal pressure-change curve of battery pack *k* is obtained, the target liquid-inlet solenoid valve of battery pack *k* is closed according to the internal pressure-change curve, and heat dissipation is performed on battery pack *k* with the liquid cooling medium. When the average temperature of battery pack *k* is lower than a second temperature, a target liquid-outlet solenoid valve of battery pack *k* is opened, and the liquid cooling medium in battery pack *k* is recovered to the liquid cooling apparatus through a liquid outlet of battery pack *k*, where the first temperature is greater than the second temperature. The target liquid-outlet solenoid valve is a liquid-outlet solenoid valve corresponding to a liquid outlet of battery pack *k.*

Optionally, in terms of obtaining the average temperature of battery pack *k* within the preset time period, the liquid cooling system illustrated in FIG. 2 can further realize the following functions. Multiple temperatures are obtained by obtaining temperatures of battery pack *k* within the preset time period, where each of the multiple temperatures corresponds to one time-point. An average of the multiple temperatures is determined. When the average is less than a preset threshold, the average temperature of battery pack *k* is obtained according to a first preset time interval.

Optionally, the liquid cooling system illustrated in FIG. 2 can further realize the following functions. When the average is greater than or equal to the preset threshold, each of the multiple temperatures and the time-point corresponding to each of the multiple temperatures are converted into a coordinate point to obtain multiple coordinate points. The multiple coordinate points are fitted to obtain a fitted straight line. A target slope of the fitted straight line is determined. A second preset time interval corresponding to the target slope is determined. The average temperature of battery pack *k* is obtained according to the second preset time interval.

Optionally, the fitted straight line is used for predicting the temperature change of battery pack *k.* In terms of opening the target liquid-inlet solenoid valve of battery pack *k* according to the temperature change, the liquid cooling system illustrated in FIG. 2 can further realize the following functions. When the target slope is greater than a preset slope, a target moment when the temperature of battery pack *k* is higher than the first temperature is determined according to the fitted straight line. When the target moment is reached, proceed to opening the target liquid-inlet solenoid valve of battery pack *k*. When the target slope is less than or equal to the preset slope, proceed to opening the target liquid-inlet solenoid valve of battery pack *k* when the average temperature of battery pack *k* is higher than the first temperature.

Optionally, in terms of closing the target liquid-inlet solenoid valve of battery pack *k* according to the internal pressure-change curve, the liquid cooling system illustrated in FIG. 2 can further realize the following functions. A target pressure-change rate in battery pack *k* is determined according to the internal pressure-change curve. A target valve-control parameter corresponding to the target pressure-change rate is determined for the target liquid-inlet solenoid valve. The target liquid-inlet solenoid valve is controlled to be closed according to the target valve-control parameter.

Optionally, the liquid cooling system illustrated in FIG. 2 can further realize the following functions. A target heat-dissipation rate of the liquid cooling medium with respect to battery pack *k* is determined. When the target heat-dissipation rate is less than a preset heat-dissipation rate, a target difference between the preset heat-dissipation rate and the target heat-dissipation rate is determined. A target backup heat-dissipation device corresponding to the target difference is determined. The target backup heat-dissipation device is controlled to dissipate heat for battery pack *k*. When the target heat-dissipation rate is greater than or equal to the preset heat-dissipation rate, proceed to closing the target liquid-outlet solenoid valve of battery pack *k* when the average temperature of battery pack *k* is lower than the second temperature.

Optionally, in terms of determining the target backup heat-dissipation device corresponding to the target difference, the liquid cooling system illustrated in FIG. 2 can further realize the following functions. A pre-configured heat-dissipation rate of each of *p* backup heat-dissipation devices is determined, to obtain *p* heat-dissipation rates, where *p* is an integer greater than or equal to 1. *q* heat-dissipation rates are selected from the *p* heat-dissipation rates, where the sum of the *q* heat-dissipation rates is greater than the target difference, and *q* is a positive integer less than or equal to *p.* Backup heat-dissipation devices corresponding to the *q* heat-dissipation rates are determined as the target backup heat-dissipation devices.

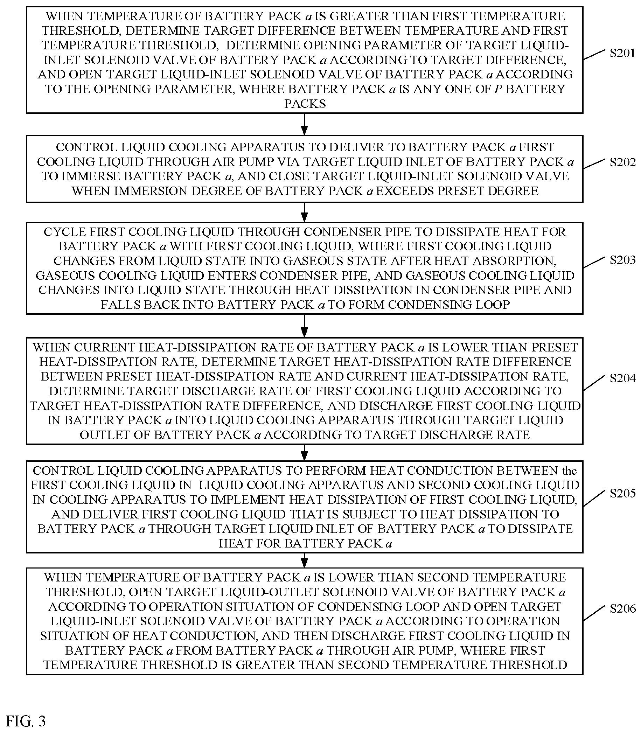

Reference is made to FIG. 3, where FIG. 3 is a schematic flowchart of a battery heat-dissipation processing method provided in embodiments of the disclosure. The method is applied to the liquid cooling system illustrated in FIG. 1. The liquid cooling system includes a liquid cooling apparatus, an air pump, a box body, a condenser pipe, and a cooling apparatus. The box body includes *P* battery packs, where *P* is a positive integer. The condenser pipe is disposed above the box body. Each of the *P* battery packs has one liquid outlet and one liquid inlet, and the one liquid outlet and the one liquid inlet are both connected to the condenser pipe. The one liquid inlet corresponds to one liquid-inlet solenoid valve, and the one liquid outlet corresponds to one liquid-outlet solenoid valve. The one liquid outlet is connected to the condenser pipe and the liquid cooling apparatus. The one liquid inlet is connected to the liquid cooling apparatus through the air pump. The cooling apparatus is connected to the liquid cooling apparatus. The liquid cooling apparatus is configured to store a first cooling liquid. The cooling apparatus is configured to store a second cooling liquid. As illustrated in FIG. 3, the method includes the following.

At S201, when a temperature of battery pack *a* is greater than a first temperature threshold, a target difference between the temperature and the first temperature threshold is determined, an opening parameter of a target liquid-inlet solenoid valve of battery pack *a* is determined according to the target difference, and the target liquid-inlet solenoid valve of battery pack *a* is opened according to the opening parameter, where battery pack *a* is any one of the *P* battery packs.

In embodiments of the disclosure, battery pack *a* is taken as an example, and battery pack *a* is any one of the *P* battery packs, and the target liquid-inlet solenoid valve is a liquid-inlet solenoid valve corresponding to a liquid inlet of battery pack *a.* A method for monitoring a temperature of a battery pack may include at least one of a temperature sensor method, an infrared thermal imager method, a heat-sensitive label method, or the like, which is not limited herein. The first temperature threshold can be preset or system default. An opening parameter of a solenoid valve may include at least one of an opening amplitude of the solenoid valve, an opening rate of the solenoid valve, an operating voltage of the solenoid valve, an operating current of the solenoid valve, an operating power of the solenoid valve, or the like, which is not limited herein.

During implementation, the infrared thermal imager method can be used for monitoring the temperature of battery pack *a.* An infrared thermal imager can detect the surface temperature distribution of battery pack *a* through infrared radiation. The infrared thermal imager can provide a temperature image of the whole battery pack or a specific area, through which the temperature of battery pack *a* can be intuitively known. A temperature measured by the infrared thermal imager can be sent to a background program and recorded by the background program.

During implementation, a difference between temperature *a* corresponding to battery pack *a* and the first temperature threshold can be calculated first, so as to obtain the target difference. Specifically, target difference = temperature *a* - first temperature threshold

Then, the opening parameter corresponding to the target difference is determined for the target liquid-inlet solenoid valve of battery pack *a.* Specifically, the opening parameter of the solenoid valve may be the operating voltage of the solenoid valve. A preset mapping relationship between differences and opening parameters of the solenoid valve can be pre-stored, the opening parameter corresponding to the target difference is determined for the solenoid valve based on the mapping relationship, and the target liquid-inlet solenoid of battery pack *a* is controlled to be opened according to the opening parameter.

As such, the target difference is obtained by calculating the difference between the temperature *a* corresponding to battery pack *a* and the first temperature threshold. Then, a corresponding opening parameter of a liquid-inlet solenoid valve of the battery pack is obtained according to the target difference, and the liquid-inlet solenoid valve is controlled to be opened according to the opening parameter. In one aspect, the temperature of the battery pack can be accurately controlled. When a temperature difference is relatively large, the liquid-inlet solenoid valve can be opened more quickly to adjust the flow of the first cooling liquid, thereby reducing the temperature of the battery pack timely, ensuring that the operating temperature of the battery pack is kept within an appropriate range, and guaranteeing the operating safety of the battery pack. In another aspect, the parameter of the solenoid valve can be controlled according to the temperature difference, and the flow of the cooling liquid can be reasonably controlled. When the temperature difference is relatively small, the liquid-inlet solenoid valve can be adjusted to allow a relatively small flow of cooling liquid to pass through and the flow of the first cooling liquid can be reasonably configured, thereby improving the utilization of the cooling liquid.

Optionally, in this embodiment, the temperature of the battery pack may be a monitored average temperature of the battery pack. Battery pack *i* is taken as an example, and battery pack *i* is any one of the *P* battery packs. Multiple temperatures are obtained by obtaining temperatures of battery pack *i* within a preset time period, where each of the multiple temperatures corresponds to one time-point. An average of the multiple temperatures is determined. When the average is less than a preset threshold, the average temperature of battery pack *i* is obtained according to a first preset time interval. When the average is greater than or equal to the preset threshold, each of the multiple temperatures and the time-point corresponding to each of the multiple temperatures are converted into a coordinate point to obtain multiple coordinate points. The multiple coordinate points are fitted to obtain a fitted straight line. A target slope of the fitted straight line is determined. A second preset time interval corresponding to the target slope is determined. The average temperature of battery pack *i* is obtained according to the second preset time interval. When the target slope is greater than a preset slope, a target moment when the temperature of battery pack *i* is higher than the first temperature threshold is determined according to the fitted straight line. When the target moment is reached, the target liquid-inlet solenoid valve of battery pack *i* is opened.

In embodiments of the disclosure, the method for obtaining the fitted straight line may include at least one of a least square method, linear regression, or the like, which is not limited herein. The target slope of the fitted straight line is a value that reflects a temperature-change trend of the battery pack. The preset time period, the preset threshold, the first preset time interval, and the preset slope all can be preset or system default.

During implementation, when the average is less than the preset threshold, the average temperature of battery pack *i* is obtained according to the first preset time interval. When the average is greater than or equal to the preset threshold, each of the multiple temperatures and the time-point corresponding to each of the multiple temperatures are converted into a coordinate point to obtain multiple coordinate points. The multiple coordinate points can be fitted in a linear regression method, so as to obtain the fitted straight line. Specifically, the multiple temperatures and corresponding time-points can be first combined into a data set of coordinate points, and then a scatter plot is drawn according to the data set. All the coordinate points are represented in a coordinate system with time as an abscissa and temperature as an ordinate. Linear regression fitting approximates to the distribution of data points by fitting a straight line. A functional form of a linear regression model may be *y* = *jx + b,* where *y* is a temperature, *x* is a time-point, *j* is a slope, and *b* is an intercept. Data is fitted in the form of a fitting function, and a slope and an intercept of the fitted straight line are calculated in the linear regression method to obtain the target slope of the fitted straight line. The fitted straight line is drawn according to the calculated slope and intercept, so that the fitted straight line approximates to the data points as much as possible, so as to represent a change trend of the data.

Then, a second preset time interval corresponding to the target slope is determined. Specifically, a preset mapping relationship between slopes of fitted straight lines and time intervals can be pre-stored, and the second preset time interval corresponding to the target slope is determined based on the mapping relationship. Next, the average temperature of battery pack i can be intermittently obtained by the system according to the second preset time interval.

Further, when the target slope is greater than the preset slope, the target moment when the temperature of battery pack *i* is higher than the first temperature threshold is determined according to the fitted straight line. When the target moment is reached, the target liquid-inlet solenoid valve of battery pack *i* is opened. Specifically, when the target slope of the fitted straight line is greater than the preset slope, the target moment when the temperature of battery pack *i* is higher than the first temperature threshold can be determined according to the fitted straight line and the target slope of the fitted straight line. Specifically, starting from an initial time for detecting the temperature of battery pack *i,* the target moment when the temperature of battery pack *i* is higher than the first temperature threshold is calculated according to the slope and the intercept of the fitted straight line. The target moment can be calculated according to the following formula: *T* = (*X*-*b*)/*j*+*t*. In the above, *T* is the target moment, *X* is the first temperature threshold, *b* is the intercept of the fitted straight line, that is, *b* is an initial temperature of the battery pack, *j* is the target slope of the fitted straight line, and *t is* a starting time of the fitted straight line. When the target moment is reached, the target liquid-inlet solenoid valve of battery pack *i* is opened.

When the target slope is less than or equal to the preset slope, the target liquid-inlet solenoid valve of battery pack *i* is opened in case where the temperature of battery pack *i* is higher than the first temperature threshold.

As such, when an average of temperatures of the battery pack is greater than or equal to the preset threshold, the fitted straight line is obtained through straight-line fitting of the multiple temperatures and the time-points corresponding to the multiple temperatures, and the target slope of the fitted straight line is calculated. Temperature data can be smoothed by fitting the straight line. Noise and fluctuations in the temperature data can be filtered out by fitting the straight line, which can provide more stable and reliable temperature data, reduce occurrence of system misjudgment and misreport, and improve the accuracy of temperature monitoring. In addition, when the target slope is greater than the preset slope, the target moment when the temperature of the battery pack is higher than the first temperature threshold can be determined according to the fitted straight line. When the target moment is reached, the target liquid-inlet solenoid valve of the battery pack is opened. Since the target moment has been known in advance, the system can make preparation in advance to inject the required first cooling liquid into the battery pack at the target moment, so that the first cooling liquid can be accurately controlled, and thus the temperature of the battery pack can be accurately adjusted.

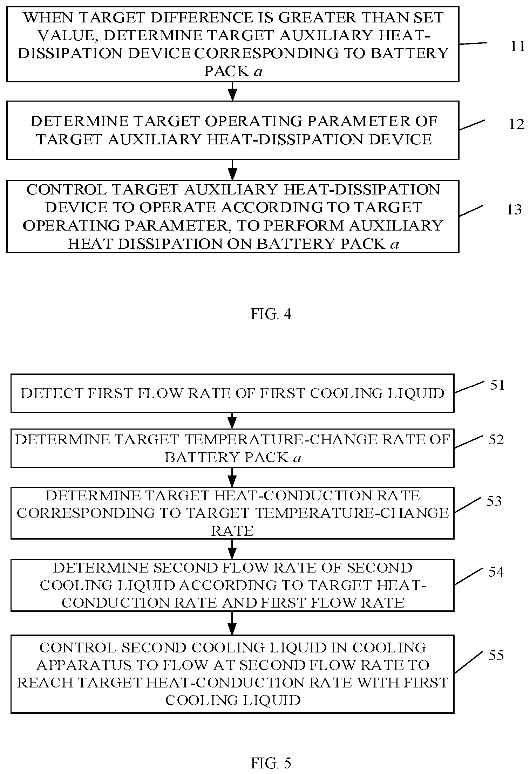

Optionally, as illustrated in FIG. 4, operations at S201 may further include operations illustrated in FIG. 4.

At 11, when the target difference is greater than a set value, a target auxiliary heat-dissipation device corresponding to battery pack *a* is determined.

At 12, a target operating parameter of the target auxiliary heat-dissipation device is determined.

At 13, the target auxiliary heat-dissipation device is controlled to operate according to the target operating parameter, to perform auxiliary heat dissipation on battery pack *a.*

In embodiments of the disclosure, the set value can be preset or system default, or may be an empirical value. When the temperature of a battery is higher than the set value, it indicates that cooling the battery pack only by the first cooling liquid is not sufficient in this case and the auxiliary heat-dissipation device is needed to dissipate heat for the battery. The auxiliary heat-dissipation device may include at least one of a fan, an air conditioner, a heat pipe radiator, or the like, which is not limited herein. Each auxiliary heat-dissipation device corresponds to one device type, and different device types may correspond to different operating parameters. An operating parameter of the fan may include at least one of a wind speed, a wind direction, an air temperature (temperature of air), an operating mode (an oscillating mode or a fixed mode), or the like, which is not limited herein. An operating parameter of the air conditioner may include at least one of a temperature, a wind speed, a wind direction, an operating mode (a cooling mode, a heating mode, or a dehumidifying mode), an operating frequency, or the like, which is not limited herein. An operating parameter of the heat pipe radiator may include at least one of a heat-dissipation rate, a heat-dissipation area, a heat-dissipation mode, or the like, which is not limited herein.

During implementation, when the target difference is greater than the set value, the target auxiliary heat-dissipation device corresponding to the battery pack *a* is determined. Specifically, the auxiliary heat-dissipation device can be determined according to an auxiliary difference between the target difference and the set value. For example, when the auxiliary difference is within 10 degrees Celsius, the fan can be selected as the auxiliary heat-dissipation device. For another example, when the auxiliary difference is above 10 degrees Celsius, the air conditioner can be selected as the auxiliary heat-dissipation device. Then, the target operating parameter of the target auxiliary heat-dissipation device is determined, and the target auxiliary heat-dissipation device is controlled to operate according to the target operating parameter, to perform auxiliary heat dissipation on the battery pack.

As such, when the target difference is greater than the set value, the auxiliary difference between the target difference and the set value is calculated first, and a type of the target auxiliary heat-dissipation device is determined according to the auxiliary difference. Then, the target operating parameter of the target auxiliary heat-dissipation device is determined, and the target auxiliary heat-dissipation device is controlled to operate according to the target operating parameter, to perform auxiliary heat dissipation on the battery pack. In this way, the heat-dissipation of the battery pack can be accelerated, which is conducive to further speeding up the reduction of the temperature of the battery pack and avoiding the influence of an excessively high temperature on the performance and service life of the battery pack.

Optionally, when the target difference is greater than the set value, determining the target auxiliary heat-dissipation device corresponding to battery pack *a* at 12 may further include the following.

At 121, a target heat-dissipation rate corresponding to the target difference is determined.

At 122, a pre-configured heat-dissipation rate of each of *p* auxiliary heat-dissipation devices is determined, to obtain *p* heat-dissipation rates, where *p* is a positive integer.

At 123, *q* heat-dissipation rates are selected from the *p* heat-dissipation rates, where a sum of the *q* heat-dissipation rates is greater than the target heat-dissipation rate, and *q* is a positive integer less than or equal to *p.*

At 124, auxiliary heat-dissipation devices corresponding to the *q* heat-dissipation rates are determined as target auxiliary heat-dissipation devices.

In embodiments of the disclosure, the target heat-dissipation rate corresponding to the target difference can be determined first. Specifically, a preset mapping relationship between differences and heat-dissipation rates can be pre-stored, and a heat-dissipation rate corresponding to the target difference is determined based on the mapping relationship. Then, the pre-configured heat-dissipation rate of each of the *p* auxiliary heat-dissipation devices can be determined. For example, a heat-dissipation rate of the fan can be configured as 1 watt per second. For another example, a heat-dissipation rate of the air conditioner can be configured as 3 watts per second. In this way, the *p* heat-dissipation rates are obtained. The *q* heat-dissipation rates are selected from the *p* heat-dissipation rates, where the sum of the *q* heat-dissipation rates is greater than the target heat-dissipation rate. The auxiliary heat-dissipation devices corresponding to the *q* heat-dissipation rates are determined as the target auxiliary heat-dissipation devices.

As such, the *p* heat-dissipation rates are obtained by configuring the heat-dissipation rates for the auxiliary heat-dissipation devices, and then the *q* auxiliary heat-dissipation devices are selected from *p* auxiliary heat-dissipation devices corresponding to the *p* heat-dissipation rates. It needs to be ensured that the sum of heat-dissipation rates of the *q* auxiliary heat-dissipation devices is greater than the target heat-dissipation rate. The auxiliary heat-dissipation devices corresponding to the *q* heat-dissipation rates are determined as the target auxiliary heat-dissipation devices. The heat-dissipation efficiency of the auxiliary heat-dissipation device can be flexibly configured according to actual situations, which can quantify the heat-dissipation effect of the auxiliary heat-dissipation device and simplify the process of selecting the target auxiliary heat-dissipation device. According to the magnitude of the target heat-dissipation rate and the heat-dissipation rates of the auxiliary heat-dissipation devices, a suitable combination of auxiliary heat-dissipation devices can be selected to satisfy the heat-dissipation demand of the battery pack, thereby ensuring that the battery pack would have a suitable heat-dissipation rate in different situations and enhancing the reliability of the system.

At S202, the liquid cooling apparatus is controlled to deliver to battery pack *a* the first cooling liquid through the air pump via a target liquid inlet of battery pack *a* to immerse battery pack *a,* and the target liquid-inlet solenoid valve is closed when an immersion degree of battery pack *a* exceeds a preset degree.

In embodiments of the disclosure, the target liquid inlet is the liquid inlet of battery pack *a,* and the preset degree can be preset or system default. The preset degree may be a liquid-level height. Alternatively, the preset degree may be a pressure.

During implementation, after the liquid-inlet solenoid valve of battery pack *a* is opened to a certain degree, the liquid cooling apparatus can be controlled to deliver the first cooling liquid to battery pack *a,* and the liquid cooling apparatus can be controlled to deliver the first cooling liquid through the air pump via the liquid inlet of battery pack *a.* Alternatively, the first cooling liquid can be delivered after the liquid-inlet solenoid valve of battery pack *a* has been opened for a time period, where the time period can be preset or system default. In addition, the preset degree may be a pressure, and a pressure sensor may be installed at the liquid-inlet solenoid valve of battery pack *a.* When the pressure sensor detects that the pressure at the target liquid-inlet solenoid valve of battery pack *a* is greater than the preset degree, the liquid-inlet solenoid valve of battery pack *a* is closed.

Optionally, when the immersion degree of battery pack *a* exceeds the preset degree, closing the target liquid-inlet solenoid valve of battery pack *a* at S202 may include the following.

At 21, a target pressure-change rate in battery pack *a* is detected.

At 22, a target valve-control parameter corresponding to the target pressure-change rate is determined for the target liquid-inlet solenoid valve.

At 23, the target liquid-inlet solenoid valve is controlled to be closed according to the target valve-control parameter.

In embodiments of the disclosure, a control parameter of the solenoid valve may include at least one of a closing amplitude of the solenoid valve, a closing rate of the solenoid valve, an operating voltage of the solenoid valve, an operating current of the solenoid valve, an operating power of the solenoid valve, or the like, which is not limited herein.

During implementation, the target pressure-change rate in battery pack *a* can be detected by the pressure sensor. Specifically, the pressure sensor may be installed on a side surface of battery pack *a,* good contact between the pressure sensor and the liquid in the battery pack needs to be ensured, and the pressure sensor is connected to the system. In this way, the system can monitor, in real time, a pressure output by the pressure sensor, record changes of the pressure over time, and calculate a pressure-change rate, so as to obtain the target pressure-change rate.

Then, the target valve-control parameter corresponding to the target pressure-change rate is determined for the target liquid-inlet solenoid valve. The target valve-control parameter may be the operating voltage of the solenoid valve. Specifically, a preset mapping relationship between pressure-change rates and valve-control parameters can be pre-stored, the target valve-control parameter corresponding to the target pressure-change rate is determined based on the mapping relationship, and the target liquid-inlet solenoid valve is controlled to be closed according to the target valve-control parameter.

As such, the target valve-control parameter of the target liquid-inlet solenoid valve of the battery pack is obtained according to the target pressure-change rate in the battery pack, and the target liquid-inlet solenoid valve is controlled to be closed according to the target valve-control parameter. By means of controlling closing of the target liquid-inlet solenoid valve, excess liquid can be prevented from entering the battery pack, so that the pressure inside the battery pack will not be too high, the safety risk inside the battery pack can be reduced, and the security of the system can be improved.

At S203, the first cooling liquid is cycled through the condenser pipe to dissipate heat for battery pack *a* with the first cooling liquid, where the first cooling liquid changes from a liquid state into a gaseous state after heat absorption, a gaseous cooling liquid enters the condenser pipe, and the gaseous cooling liquid changes into the liquid state through heat dissipation in the condenser pipe and falls back into battery pack *a* to form a condensing loop.

In embodiments of the disclosure, the condenser pipe contains a coolant, and the coolant may be water. For example, water can be pre-filled into the condenser pipe.

During implementation, the first cooling liquid is cycled through the condenser pipe. Specifically, the first cooling liquid first dissipates heat for battery pack *a.* After absorption of the heat of battery pack *a,* the first cooling liquid changes from the liquid state into the gaseous state. The first cooling liquid in the gaseous state enters the condenser pipe. The first cooling liquid in the gaseous state is subject to heat dissipation in the condenser pipe, and the coolant in the condenser pipe exchanges heat with the first cooling liquid in the gaseous state. The first cooling liquid in the gaseous state, with a decrease in the temperature, changes into the liquid state again and falls back into battery pack *a* to form the condensing loop.

At S204, when a current heat-dissipation rate of battery pack *a* is lower than a preset heat-dissipation rate, a target heat-dissipation rate difference between the preset heat-dissipation rate and the current heat-dissipation rate is determined, a target discharge rate of the first cooling liquid is determined according to the target heat-dissipation rate difference, and the first cooling liquid in battery pack *a* is discharged into the liquid cooling apparatus through a target liquid outlet of battery pack *a* according to the target discharge rate.

In embodiments of the disclosure, the target liquid outlet is a liquid outlet of battery pack *a,* and the preset heat-dissipation rate can be preset or system default.

Specifically, the current heat-dissipation rate of battery pack *a* can be obtained by the infrared thermal imager through measurement. Then, the target heat-dissipation rate difference between the preset heat-dissipation rate and the current heat-dissipation rate is calculated, and the target discharge rate of the first cooling liquid is determined according to the target heat-dissipation rate difference. Specifically, a preset mapping relationship between heat-dissipation rate differences and discharge rates can be pre-stored, the target discharge rate corresponding to the target heat-dissipation rate difference is determined based on the mapping relationship, and the first cooling liquid in battery pack *a* is discharged into the liquid cooling apparatus through the target liquid outlet of battery pack *a* according to the target discharge rate.

At S205, the liquid cooling apparatus is controlled to perform heat conduction between the first cooling liquid in the liquid cooling apparatus and the second cooling liquid in the cooling apparatus to implement heat dissipation of the first cooling liquid, and the first cooling liquid that is subject to heat dissipation is delivered to battery pack *a* through the target liquid inlet of battery pack *a* to dissipate heat for battery pack *a.*

In embodiments of the disclosure, the liquid cooling system may control the liquid cooling apparatus to deliver the first cooling liquid to the cooling apparatus. The first cooling liquid is cycled in the cooling apparatus to conduct heat with the second cooling liquid, the first cooling liquid returns to the liquid cooling apparatus after completion of heat dissipation, and then the first cooling liquid that is subject to heat dissipation is delivered to battery pack *a* again through the target liquid inlet of battery pack *a,* so as to continue to dissipate heat for battery pack *a.*

Optionally, as illustrated in FIG. 5, controlling the liquid cooling apparatus to perform heat conduction between the first cooling liquid in the liquid cooling apparatus and the second cooling liquid in the cooling apparatus at S205 may further include operations in FIG. 5.

At 51, a first flow rate of the first cooling liquid is detected.

At 52, a target temperature-change rate of battery pack *a* is determined.

At 53, a target heat-conduction rate corresponding to the target temperature-change rate is determined.

At 54, a second flow rate of the second cooling liquid is determined according to the target heat-conduction rate and the first flow rate.

At 55, the second cooling liquid in the cooling apparatus is controlled to flow at the second flow rate to reach the target heat-conduction rate with the first cooling liquid.

In embodiments, the first flow rate of the first cooling liquid refers to a cycling rate of the first cooling liquid in the cooling apparatus. The heat-conduction rate refers to a rate of heat exchange between the first cooling liquid in the liquid cooling apparatus and the second cooling liquid in the cooling apparatus.

In embodiments of the disclosure, a sensor for detecting the first flow rate may include at least one of a flowmeter, a pressure-difference sensor, a temperature transducer, or the like, which is not limited herein. A method for determining the temperature-change rate may include at least one of a thermistor method, a heat-flow-meter method, a digital temperature sensor method, or the like, which is not limited herein.

During implementation, the flowmeter can be installed to detect the first flow rate of the first cooling liquid. Specifically, a turbine flowmeter may be selected, and the flowmeter is installed on a pipeline of a liquid inlet or a liquid outlet of the cooling apparatus. During operation of the cooling apparatus, the first flow rate of the first cooling liquid can be obtained through observation of a reading on the flowmeter. Likewise, the target temperature-change rate of battery pack *a* can be determined in the heat-flow-meter method, where a heat-flow-meter is a device for measuring temperature changes based on the principle of heat transfer. Specifically, one heat-flow-meter can be disposed to monitor the temperature of battery pack *a* in real time, and the temperature-change rate of battery pack *a* can be obtained through measurement of heat output by the heat-flow-meter.

Then, the target heat-conduction rate corresponding to the target temperature-change rate is determined. Specifically, a preset mapping relationship between temperature-change rates and heat-conduction rates can be pre-stored, the target heat-conduction rate corresponding to the target temperature-change rate is determined based on the mapping relationship, and then a second flow rate of the second cooling liquid is determined according to the target heat-conduction rate and the first flow rate. Specifically, the heat-conduction rate, the first flow rate, and the second flow rate satisfy a heat-conduction function f(*v1, v2*) = *y,* where *y* is the heat-conduction rate, *v1* is the first flow rate, *v2* is the second flow rate. Since y and *v1* have been obtained, the second flow rate *v2* of the second cooling liquid can be calculated according to the heat-conduction function.

Further, after the second flow rate is obtained, the first cooling liquid flows at the first flow rate in the cooling apparatus, and the second cooling liquid in the cooling apparatus can be controlled to flow at the second flow rate. In this way, it can be ensured that the heat-conduction rate between the first cooling liquid and the second cooling liquid reaches the target heat-conduction rate.

As such, the target heat-conduction rate corresponding to the target temperature-change rate of battery pack *a* is determined, so that the heat-conduction stability can be ensured. A flow rate of the second cooling liquid is determined according to the first flow rate and the target heat-conduction rate, so that the heat-conduction rate between the first cooling liquid and the second cooling liquid reaches the target heat-conduction rate, thereby ensuring the heat-conduction stability and the heat-conduction efficiency. Therefore, heat can be smoothly transferred from the first cooling liquid to the second cooling liquid, and thus the thermal management performance of the liquid cooling system is improved.

At S206, when the temperature of battery pack *a* is lower than a second temperature threshold, a target liquid-outlet solenoid valve of battery pack *a* is opened according to an operation situation of the condensing loop and the target liquid-inlet solenoid valve of battery pack *a* is opened according to an operation situation of the heat conduction, and then the first cooling liquid in battery pack *a* is discharged from battery pack *a* through the air pump, where the first temperature threshold is greater than the second temperature threshold.

In embodiments of the disclosure, the target liquid-outlet solenoid valve is a liquid-outlet solenoid valve corresponding to the target liquid outlet of battery pack *a.* The second temperature threshold can be preset or system default. When it is determined that the temperature of battery pack *a* is lower than the second temperature threshold, the target liquid-outlet solenoid valve of battery pack *a* is opened according to the operation situation of the condensing loop and the target liquid-inlet solenoid valve of battery pack *a* is opened according to the operation situation of the heat conduction. Then the first cooling liquid in battery pack *a* is discharged from the target liquid outlet of battery pack *a* through the air pump. Alternatively, the first cooling liquid in battery pack *a* is discharged from the target liquid inlet of battery pack *a* through the air pump. Alternatively, the first cooling liquid in battery pack *a* is discharged from the target liquid outlet and the target liquid inlet of battery pack *a* through the air pump.

Optionally, opening the target liquid-outlet solenoid valve of battery pack *a* according to the operation situation of the condensing loop and the target liquid-inlet solenoid valve of battery pack *a* according to the operation situation of the heat conduction at 206 may include the following.

At A1, a target fallback rate for the condensing loop is determined.

At A2, a target conduction rate for the heat conduction is determined.

At A3, a first control parameter corresponding to the target fallback rate is determined.

At A4, a second control parameter corresponding to the target conduction rate is determined.

At A5, the target liquid-outlet solenoid valve of battery pack *a* is controlled to be opened according to the first control parameter.

At A6, the target liquid-inlet solenoid valve of battery pack *a* is controlled to be opened according to the second control parameter.

In embodiments of the disclosure, the liquid cooling system can monitor a fallback rate for the condensing loop and a conduction rate for the heat conduction in real time. Further, the liquid cooling system can determine the target fallback rate for the condensing loop and the target conduction rate for the heat conduction.

Further, the target liquid-outlet solenoid valve of battery pack *a* can be adjusted according to the target fallback rate, and the target liquid-inlet solenoid valve of battery pack *a* can be adjusted according to the target conduction rate. Specifically, a preset mapping relationship between fallback rates and control parameters of a liquid-outlet solenoid valve can be pre-stored, the first control parameter corresponding to the target fallback rate can be determined for the liquid-outlet solenoid valve according to the mapping relationship, and then the target liquid-outlet solenoid valve is opened according to the first control parameter. In addition, a preset mapping relationship between conduction rates and control parameters of a liquid-inlet solenoid valve can be pre-stored, the second control parameter corresponding to the target conduction rate can be determined for the liquid-inlet solenoid valve according to the mapping relationship, and then the target liquid-inlet solenoid valve is opened according to the second control parameter.

As such, the target fallback rate for the condensing loop and the target conduction rate for the heat conduction are obtained first. Then, the first control parameter corresponding to the target fallback rate and the second control parameter corresponding to the target conduction rate are obtained. The target liquid-outlet solenoid valve is opened according to the first control parameter, and the target liquid-inlet solenoid valve is opened according to the second control parameter. Through adjustment of the solenoid valve, it can be ensured that the heat-conduction rate between the liquid cooling apparatus and the cooling apparatus is adapted to the target conduction rate, thereby reducing the risk of overheating or overcooling and improving the safety during cooling of the battery pack. In addition, through accurate control of the operating parameter of the solenoid valve, the flow and flow rate of the first cooling liquid can be reasonably configured, which can improve the cooling effect of the battery pack, stabilize the operating environment of the battery pack, and thus improve the operating efficiency of the battery pack.

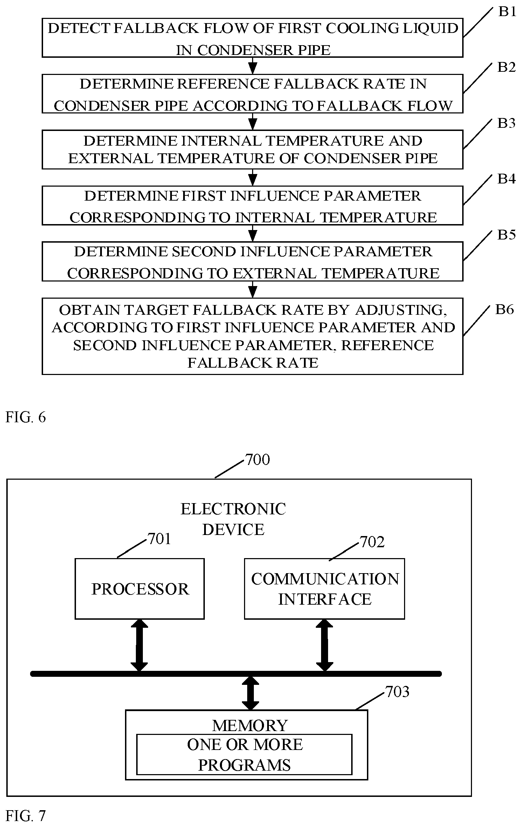

Optionally, as illustrated in FIG. 6, determining the target fallback rate for the condensing loop at A1 may include operations in FIG. 6.

At B1, a fallback flow of the first cooling liquid in the condenser pipe is detected.

At B2, a reference fallback rate in the condenser pipe is determined according to the fallback flow.

At B3, an internal temperature and an external temperature of the condenser pipe are determined.

At B4, a first influence parameter corresponding to the internal temperature is determined.

At B5, a second influence parameter corresponding to the external temperature is determined.

At B6, the target fallback rate is obtained by adjusting, according to the first influence parameter and the second influence parameter, the reference fallback rate.

In embodiments, a method for detecting the fallback flow may include at least one of a flowmeter method, a pressure-difference measurement method, a liquid-level change measurement method, or the like, which is not limited herein. A device for measuring the temperature of the condenser pipe may include at least one of a temperature transducer, an infrared thermal imager, a pipe-wall temperature transducer, or the like, which is not limited herein.

In embodiments of the disclosure, the fallback flow of the first cooling liquid in the condenser pipe can be detected in the pressure-difference measurement method. Specifically, pressure-difference sensors can be respectively installed at an inlet and an outlet of the condenser pipe, to measure a pressure difference that is generated when the cooling liquid passes through the condenser pipe. The pressure-difference sensors are installed at appropriate locations and are tightly connected to the condenser pipe, so as to avoid leakage and errors. After the pressure-difference sensors are installed, a mapping relationship between pressure differences and flows can be pre-established. When the first cooling liquid in the condenser pipe starts to flow, the pressure difference obtained by the pressure-difference sensors is recorded. According to the pressure difference obtained by the pressure-difference sensors, the fallback flow corresponding to the pressure difference of the first cooling liquid in the condenser pipe is determined based on the pre-stored mapping relationship between the pressure differences and the flows. In addition, a preset mapping relationship between fallback flows and fallback rates can be pre-stored, and the reference fallback rate corresponding to the fallback flow of the first cooling liquid in the condenser pipe is determined based on the mapping relationship.

Then, the internal temperature and the external temperature of the condenser pipe are determined. The internal temperature and the external temperature of the condenser pipe can be measured by the pipe-wall temperature sensors. The pipe-wall temperature sensors can be installed on an inner surface and an outer surface of the condenser pipe, respectively. For measurement of the internal temperature, the sensor can be installed on an inner wall of the condenser pipe. For measurement of the external temperature, the sensor can be tightly attached to an outer wall of the condenser pipe to ensure good contact between the sensor and the condenser pipe, so that an accurate temperature measurement can be obtained. After the internal temperature and the external temperature of the condenser pipe are measured, the first influence parameter corresponding to the internal temperature is determined, and the second influence parameter corresponding to the external temperature is determined. Specifically, a preset mapping relationship between internal temperatures and influence parameters can be preset, and the first influence parameter corresponding to the internal temperature can be determined based on the mapping relationship, where the value of a first adjustment parameter ranges from -0.3 to 0.3. In addition, a preset mapping relationship between external temperatures and influence parameters can also be preset, and the second influence parameter corresponding to the external temperature can be determined based on the mapping relationship, where the value of the second adjustment parameter ranges from -0.12 to 0.12. The target fallback rate is obtained by adjusting, according to the first influence parameter and the second influence parameter, the reference fallback rate. Specifically, target fallback rate = (1 + first influence parameter) * (1 + second influence parameter) * reference fallback rate

As such, the reference fallback rate in the condenser pipe can be obtained according to the fallback flow in the condenser pipe. In addition, the reference fallback rate can be adjusted according to internal and external operating environments of the condenser pipe, so that a target fallback rate which is more suitable for a current operating state of the condenser pipe can be obtained. When a fallback rate in the condenser pipe matches with the environment, the heat can be transferred more effectively, so that the cooling speed of the battery pack can be accelerated, the battery pack will not overheat, and thus the cooling efficiency of the battery pack can be improved.

Optionally, after operations at B6, the method may further include the following.

At C1, a flow rate of the first cooling liquid in battery pack *a* is determined.

At C2, a target ratio of the target fallback rate to the flow rate of the first cooling liquid in battery pack *a* is determined.

At C3, the liquid cooling apparatus is controlled to perform heat conduction between the first cooling liquid in the liquid cooling apparatus and the second cooling liquid in the cooling apparatus.

In embodiments of the disclosure, a device for detecting the flow rate of the first cooling liquid may include at least one of a pressure sensor, a flow sensor, an optical sensor, or the like, which is not limited herein.

During implementation, the optical sensor can be selected to measure the flow rate of the first cooling liquid, and the optical sensor can be an optical fiber sensor or a photoelectric sensor. The optical sensor is installed at a location through which the first cooling liquid flows in the battery pack while ensuring sufficient contact between the sensor and the cooling liquid, so that the flow rate can be measured accurately. When the first cooling liquid starts to flow, the optical sensor can measure the flow rate in real time. During the measurement, the optical sensor can continuously monitor the flow rate of the first cooling liquid in the battery pack and transmit data to the liquid cooling system. Then, the target ratio of the target fallback rate to the flow rate of the first cooling liquid in battery pack *a* is determined. Specifically, target ratio = target fallback rate/flow rate of first cooling liquid. Next, the liquid cooling apparatus is controlled to perform heat conduction between the first cooling liquid in the liquid cooling apparatus and the second cooling liquid in the cooling apparatus.

As such, the flow rate of the first cooling liquid in the battery pack is obtained, and then the target ratio of the target fallback rate to the flow rate of the first cooling liquid in the battery pack is calculated. After the target ratio is determined, the liquid cooling apparatus is controlled to perform heat conduction between the first cooling liquid in the liquid cooling apparatus and the second cooling liquid in the cooling apparatus. The obtained flow rate of the first cooling liquid is conducive to understanding the cooling conditions of the battery pack, which can provide a reference for thermal management of the battery pack. Through calculation of the target ratio, it can be ensured that the flow rate of the first cooling liquid is stable, and the stable flow of the cooling liquid can keep the temperature of the system stable, so that the influence of temperature fluctuations on the performance of the system can be reduced, thereby improving the stability of the system.

Optionally, controlling the liquid cooling apparatus to perform heat conduction between the first cooling liquid in the liquid cooling apparatus and the second cooling liquid in the cooling apparatus at C3 may include the following.

At D 1, a first target heat-conduction rate is determined according to the target ratio.

At D2, the liquid cooling apparatus is controlled to perform heat conduction between the first cooling liquid in the liquid cooling apparatus and the second cooling liquid in the cooling apparatus according to the first target heat-conduction rate.

In embodiments of the disclosure, the liquid cooling apparatus can perform heat conduction between the first cooling liquid in the liquid cooling apparatus and the second cooling liquid in the cooling apparatus, preset a preset mapping relationship between ratios and heat-conduction rates, and determine the first target heat-conduction rate corresponding to the target ratio based on the mapping relationship, where the ratio refers to a ratio of the fallback rate in the condenser pipe to the flow rate of the first cooling liquid in the battery pack. The liquid cooling apparatus is controlled to perform heat conduction between the first cooling liquid in the liquid cooling apparatus and the second cooling liquid in the cooling apparatus according to the first target heat-conduction rate. In this way, the flow rate of the first cooling liquid in the battery pack is obtained first, and then the target ratio of the target fallback rate to the flow rate of the first cooling liquid in the battery pack is calculated. A first heat-conduction rate between the first cooling liquid and the second cooling liquid is obtained according to the target ratio, and the first cooling liquid in the liquid cooling apparatus is controlled to conduct heat with the second cooling liquid in the cooling apparatus according to the first target heat-conduction rate. The heat-conduction rate is determined according to the target ratio, which can optimize the heat-conduction efficiency between the cooling apparatus and the liquid cooling apparatus, so that the cooling apparatus can better cool the first cooling liquid to accelerate the cooling of the first cooling liquid. After being cooled, the first cooling liquid can cool the battery pack again, thereby improving the efficiency of the liquid cooling system.

It may be noted that in embodiments of the disclosure, except for methods related to the condenser pipe and the cooling apparatus, other methods can be applied to the liquid cooling systems illustrated in FIG. 1 and FIG. 2.

As can be seen, the battery heat-dissipation processing method described in embodiments of the disclosure is applied to the liquid cooling system. The liquid cooling system includes a liquid cooling apparatus, an air pump, a box body, a condenser pipe, and a cooling apparatus. The box body includes P battery packs, where P is a positive integer. The condenser pipe is disposed above the box body. Each of the P battery packs has one liquid outlet and one liquid inlet, and the one liquid outlet and the one liquid inlet are both connected to the condenser pipe. The one liquid inlet corresponds to one liquid-inlet solenoid valve, and the one liquid outlet corresponds to one liquid-outlet solenoid valve. The one liquid outlet is connected to the condenser pipe and the liquid cooling apparatus. The one liquid inlet is connected to the liquid cooling apparatus through the air pump. The cooling apparatus is connected to the liquid cooling apparatus. The liquid cooling apparatus is configured to store a first cooling liquid. The cooling apparatus is configured to store a second cooling liquid. When a temperature of battery pack *a* is greater than a first temperature threshold, a target difference between the temperature and the first temperature threshold is determined, an opening parameter of a target liquid-inlet solenoid valve of battery pack *a* is determined according to the target difference, and the target liquid-inlet solenoid valve of battery pack *a* is opened according to the opening parameter, where battery pack *a* is any one of the P battery packs. The liquid cooling apparatus is controlled to deliver to battery pack *a* the first cooling liquid through the air pump via a target liquid inlet of battery pack *a* to immerse battery pack *a,* and the target liquid-inlet solenoid valve is closed when an immersion degree of battery pack *a* exceeds a preset degree. The first cooling liquid is cycled through the condenser pipe to dissipate heat for battery pack *a* with the first cooling liquid, where the first cooling liquid changes from a liquid state into a gaseous state after heat absorption, a gaseous cooling liquid enters the condenser pipe, and the gaseous cooling liquid changes into the liquid state through heat dissipation in the condenser pipe and falls back into battery pack *a* to form a condensing loop. When a current heat-dissipation rate of battery pack *a* is lower than a preset heat-dissipation rate, a target heat-dissipation rate difference between the preset heat-dissipation rate and the current heat-dissipation rate is determined, a target discharge rate of the first cooling liquid is determined according to the target heat-dissipation rate difference, and the first cooling liquid in battery pack *a* is discharged into the liquid cooling apparatus through a target liquid outlet of battery pack *a* according to the target discharge rate. The liquid cooling apparatus is controlled to perform heat conduction between the first cooling liquid in the liquid cooling apparatus and the second cooling liquid in the cooling apparatus to implement heat dissipation of the first cooling liquid, and the first cooling liquid that is subject to heat dissipation is delivered to battery pack *a* through the target liquid inlet of battery pack *a* to dissipate heat for battery pack *a.* When the temperature of battery pack *a* is lower than a second temperature threshold, a target liquid-outlet solenoid valve of battery pack *a* is opened according to an operation situation of the condensing loop and the target liquid-inlet solenoid valve of battery pack *a* is opened according to an operation situation of the heat conduction, and then the first cooling liquid in battery pack *a* is discharged from battery pack *a* through the air pump, where the first temperature threshold is greater than the second temperature threshold. In this way, the temperature of the battery pack is monitored in real time, so that abnormalities can be discovered in time, heat dissipation can be performed on the battery in time, and thus the safety of the battery pack can be guaranteed. In addition, when it is detected that the temperature of the battery pack is lower than the second temperature threshold, the liquid-outlet solenoid valve and the liquid-inlet solenoid valve of the battery pack are opened to discharge the first cooling liquid from the battery pack, so that the circulation speed of the first cooling liquid inside the battery pack is increased, the discharge rate is fast, and thus the heat-dissipation effect of the battery is improved.

Consistent with the above embodiments, reference is made to FIG. 7, where FIG. 7 is a schematic structural view of an electronic device provided in embodiments of the disclosure. As illustrated in FIG. 7, the electronic device 700 includes a processor 701, a memory 703, a communication interface 702, and one or more programs. The electronic device 700 is applied to a liquid cooling system. The liquid cooling system includes a liquid cooling apparatus, an air pump, a box body, a condenser pipe, and a cooling apparatus. The box body includes *P* battery packs, where *P* is a positive integer. The condenser pipe is disposed above the box body. Each of the *P* battery packs has one liquid outlet and one liquid inlet, and the one liquid outlet and the one liquid inlet are both connected to the condenser pipe. The one liquid inlet corresponds to one liquid-inlet solenoid valve, and the one liquid outlet corresponds to one liquid-outlet solenoid valve. The one liquid outlet is connected to the condenser pipe and the liquid cooling apparatus. The one liquid inlet is connected to the liquid cooling apparatus through the air pump. The cooling apparatus is connected to the liquid cooling apparatus. The liquid cooling apparatus is configured to store a first cooling liquid. The cooling apparatus is configured to store a second cooling liquid. The one or more programs are stored in the memory 703 and configured to be executed by the processor 701. In embodiments of the disclosure, the above programs contain instructions for executing the following operations. When a temperature of battery pack *a* is greater than a first temperature threshold, a target difference between the temperature and the first temperature threshold is determined, an opening parameter of a target liquid-inlet solenoid valve of battery pack *a* is determined according to the target difference, and the target liquid-inlet solenoid valve of battery pack *a* is opened according to the opening parameter, where battery pack *a* is any one of the *P* battery packs, and the target liquid-inlet solenoid valve is a liquid-inlet solenoid valve corresponding to a liquid inlet of battery pack *a.* The liquid cooling apparatus is controlled to deliver to battery pack *a* the first cooling liquid through the air pump via a target liquid inlet of battery pack *a* to immerse battery pack *a,* and the target liquid-inlet solenoid valve is closed when an immersion degree of battery pack *a* exceeds a preset degree, where the target liquid inlet is an liquid inlet of battery pack *a.* The first cooling liquid is cycled through the condenser pipe to dissipate heat for battery pack *a* with the first cooling liquid, where the first cooling liquid changes from a liquid state into a gaseous state after heat absorption, a gaseous cooling liquid enters the condenser pipe, and the gaseous cooling liquid changes into the liquid state through heat dissipation in the condenser pipe and falls back into battery pack *a* to form a condensing loop. When a current heat-dissipation rate of battery pack *a* is lower than a preset heat-dissipation rate, a target heat-dissipation rate difference between the preset heat-dissipation rate and the current heat-dissipation rate is determined, a target discharge rate of the first cooling liquid is determined according to the target heat-dissipation rate difference, and the first cooling liquid in battery pack *a* is discharged into the liquid cooling apparatus through a target liquid outlet of battery pack *a* according to the target discharge rate, where the target liquid outlet is a liquid outlet of battery pack *a.* The liquid cooling apparatus is controlled to perform heat conduction between the first cooling liquid in the liquid cooling apparatus and the second cooling liquid in the cooling apparatus to implement heat dissipation of the first cooling liquid, and the first cooling liquid that is subject to heat dissipation is delivered to battery pack *a* through the target liquid inlet of battery pack *a* to dissipate heat for battery pack *a.* When the temperature of battery pack *a* is lower than a second temperature threshold, a target liquid-outlet solenoid valve of battery pack *a* is opened according to an operation situation of the condensing loop and the target liquid-inlet solenoid valve of battery pack *a* is opened according to an operation situation of the heat conduction, and then the first cooling liquid in battery pack *a* is discharged from battery pack *a* through the air pump, where the first temperature threshold is greater than the second temperature threshold, and the target liquid-outlet solenoid valve is a liquid-outlet solenoid valve corresponding to the target liquid outlet of battery pack *a.*

Optionally, in terms of opening the target liquid-outlet solenoid valve of battery pack *a* according to the operation situation of the condensing loop and the target liquid-inlet solenoid valve of battery pack *a* according to the operation situation of the heat conduction, the above programs further contain instructions for executing the following operations. A target fallback rate for the condensing loop is determined. A target conduction rate for the heat conduction is determined. A first control parameter corresponding to the target fallback rate is determined. A second control parameter corresponding to the target conduction rate is determined. The target liquid-outlet solenoid valve of battery pack *a* is controlled to be opened according to the first control parameter. The target liquid-inlet solenoid valve of battery pack *a* is controlled to be opened according to the second control parameter.

Optionally, in terms of determining the target fallback rate for the condensing loop, the above programs further contain instructions for executing the following operations. A fallback flow of the first cooling liquid in the condenser pipe is detected. A reference fallback rate in the condenser pipe is determined according to the fallback flow. An internal temperature and an external temperature of the condenser pipe are determined. A first influence parameter corresponding to the internal temperature is determined. A second influence parameter corresponding to the external temperature is determined. The target fallback rate is obtained by adjusting, according to the first influence parameter and the second influence parameter, the reference fallback rate.

Optionally, the above programs further contain instructions for executing the following operations. A flow rate of the first cooling liquid in battery pack *a* is determined. A target ratio of the target fallback rate to the flow rate of the first cooling liquid in battery pack *a* is determined. The liquid cooling apparatus is controlled to perform heat conduction between the first cooling liquid in the liquid cooling apparatus and the second cooling liquid in the cooling apparatus as follows. A first target heat-conduction rate is determined according to the target ratio. The liquid cooling apparatus is controlled to perform heat conduction between the first cooling liquid in the liquid cooling apparatus and the second cooling liquid in the cooling apparatus according to the first target heat-conduction rate.

Optionally, in terms of controlling the liquid cooling apparatus to perform heat conduction between the first cooling liquid in the liquid cooling apparatus and the second cooling liquid in the cooling apparatus, the above programs further contain instructions for executing the following operations. A first flow rate of the first cooling liquid is detected. A target temperature-change rate of battery pack *a* is determined. A target heat-conduction rate corresponding to the target temperature-change rate is determined. A second flow rate of the second cooling liquid is determined according to the target heat-conduction rate and the first flow rate. The second cooling liquid in the cooling apparatus is controlled to flow at the second flow rate to reach the target heat-conduction rate with the first cooling liquid.

Optionally, the above programs further contain instructions for executing the following operations. When the target difference is greater than a set value, a target auxiliary heat-dissipation device corresponding to battery pack *a* is determined. A target operating parameter of the target auxiliary heat-dissipation device is determined. The target auxiliary heat-dissipation device is controlled to operate according to the target operating parameter, to perform auxiliary heat dissipation on battery pack *a.*

Optionally, in terms of determining the target auxiliary heat-dissipation device corresponding to battery pack *a* when the target difference is greater than the set value, the above programs further contain instructions for executing the following operations. A target heat-dissipation rate corresponding to the target difference is determined. A pre-configured heat-dissipation rate of each of *p* auxiliary heat-dissipation devices is determined, to obtain *p* heat-dissipation rates, where *p* is a positive integer. *q* heat-dissipation rates are selected from the *p* heat-dissipation rates, where a sum of the *q* heat-dissipation rates is greater than the target heat-dissipation rate, and *q* is a positive integer less than or equal to *p.* Auxiliary heat-dissipation devices corresponding to the *q* heat-dissipation rates are determined as target auxiliary heat-dissipation devices.

Optionally, in terms of closing the target liquid-inlet solenoid valve of battery pack *a* when the immersion degree of battery pack *a* exceeds the preset degree, the above programs further contain instructions for executing the following operations. A target pressure-change rate in battery pack *a* is detected. A target valve-control parameter corresponding to the target pressure-change rate is determined for the target liquid-inlet solenoid valve. The target liquid-inlet solenoid valve is controlled to be closed according to the target valve-control parameter.

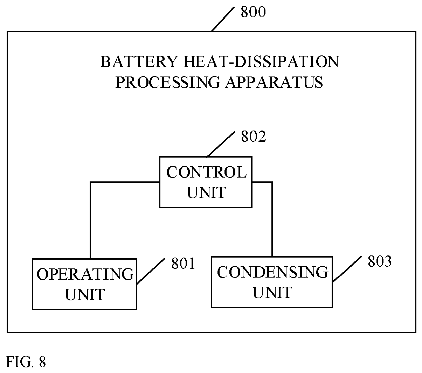

FIG. 8 is a block diagram of functional units of a battery heat-dissipation processing apparatus 800 provided in embodiments of the disclosure. The apparatus 800 is applied to a liquid cooling system. The liquid cooling system includes a liquid cooling apparatus, an air pump, a box body, a condenser pipe, and a cooling apparatus. The box body includes *P* battery packs, where *P* is a positive integer. The condenser pipe is disposed above the box body. Each of the *P* battery packs has one liquid outlet and one liquid inlet, and the one liquid outlet and the one liquid inlet are both connected to the condenser pipe. The one liquid inlet corresponds to one liquid-inlet solenoid valve, and the one liquid outlet corresponds to one liquid-outlet solenoid valve. The one liquid outlet is connected to the condenser pipe and the liquid cooling apparatus. The one liquid inlet is connected to the liquid cooling apparatus through the air pump. The cooling apparatus is connected to the liquid cooling apparatus. The liquid cooling apparatus is configured to store a first cooling liquid. The cooling apparatus is configured to store a second cooling liquid. The battery heat-dissipation processing apparatus 800 includes an operating unit 801, a control unit 802, and a condensing unit 803. The operating unit 801 is configured to determine a target difference between a temperature of battery pack *a* and a first temperature threshold, determine an opening parameter of a target liquid-inlet solenoid valve of battery pack *a* according to the target difference, and open the target liquid-inlet solenoid valve of battery pack *a* according to the opening parameter when the temperature is greater than the first temperature threshold, where battery pack *a* is any one of the *P* battery packs, and the target liquid-inlet solenoid valve is a liquid-inlet solenoid valve corresponding to a liquid inlet of battery pack *a.* The control unit 802 is configured to control the liquid cooling apparatus to deliver to battery pack *a* the first cooling liquid through the air pump via a target liquid inlet of battery pack *a* to immerse battery pack *a,* and close the target liquid-inlet solenoid valve when an immersion degree of battery pack *a* exceeds a preset degree, where the target liquid inlet is the liquid inlet of battery pack *a.* The condensing unit 803 is configured to cycle the first cooling liquid through the condenser pipe to dissipate heat for battery pack *a* with the first cooling liquid, where the first cooling liquid changes from a liquid state into a gaseous state after heat absorption, a gaseous cooling liquid enters the condenser pipe, and the gaseous cooling liquid changes into the liquid state through heat dissipation in the condenser pipe and falls back into battery pack *a* to form a condensing loop. The control unit 802 is further configured to determine a target heat-dissipation rate difference between a preset heat-dissipation rate and a current heat-dissipation rate of battery pack *a,* determine a target discharge rate of the first cooling liquid according to the target heat-dissipation rate difference, and discharge the first cooling liquid in battery pack *a* into the liquid cooling apparatus through a target liquid outlet of battery pack *a* according to the target discharge rate when the current heat-dissipation rate is lower than the preset heat-dissipation rate, where the target liquid outlet is a liquid outlet of battery pack *a.* The control unit 802 is further configured to control the liquid cooling apparatus to perform heat conduction between the first cooling liquid in the liquid cooling apparatus and the second cooling liquid in the cooling apparatus to implement heat dissipation of the first cooling liquid, and deliver, through the target liquid inlet of battery pack *a,* the first cooling liquid that is subject to heat dissipation to battery pack *a* to dissipate heat for battery pack *a.* The operating unit 801 is further configured to open a target liquid-outlet solenoid valve of battery pack *a* according to an operation situation of the condensing loop and the target liquid-inlet solenoid valve of battery pack *a* according to an operation situation of the heat conduction, and then discharge from battery pack *a* the first cooling liquid in battery pack *a* through the air pump when the temperature of battery pack *a* is lower than a second temperature threshold, where the first temperature threshold is greater than the second temperature threshold, and the target liquid-outlet solenoid valve is a liquid-outlet solenoid valve corresponding to the target liquid outlet of battery pack *a.*

Optionally, in terms of opening the target liquid-outlet solenoid valve of battery pack *a* according to the operation situation of the condensing loop and the target liquid-inlet solenoid valve of battery pack *a* according to the operation situation of the heat conduction, the operating unit 801 is further configured to determine a target fallback rate for the condensing loop, determine a target conduction rate for the heat conduction, determine a first control parameter corresponding to the target fallback rate, determine a second control parameter corresponding to the target conduction rate, control the target liquid-outlet solenoid valve of battery pack *a* to be opened according to the first control parameter, and control the target liquid-inlet solenoid valve of battery pack *a* to be opened according to the second control parameter.

Optionally, in terms of determining the target fallback rate for the condensing loop, the battery heat-dissipation processing apparatus 800 is further configured to detect a fallback flow of the first cooling liquid in the condenser pipe, determine a reference fallback rate in the condenser pipe according to the fallback flow, determine an internal temperature and an external temperature of the condenser pipe, determine a first influence parameter corresponding to the internal temperature, determine a second influence parameter corresponding to the external temperature, and obtain the target fallback rate by adjusting, according to the first influence parameter and the second influence parameter, the reference fallback rate.

Optionally, the battery heat-dissipation processing apparatus 800 is further configured to determine a flow rate of the first cooling liquid in battery pack *a,* and determine a target ratio of the target fallback rate to the flow rate of the first cooling liquid in battery pack *a.* In terms of controlling the liquid cooling apparatus to perform heat conduction between the first cooling liquid in the liquid cooling apparatus and the second cooling liquid in the cooling apparatus, the battery heat-dissipation processing apparatus 800 is further configured to determine a first target heat-conduction rate according to the target ratio, and control the liquid cooling apparatus to perform heat conduction between the first cooling liquid in the liquid cooling apparatus and the second cooling liquid in the cooling apparatus according to the first target heat-conduction rate.

Optionally, in terms of controlling the liquid cooling apparatus to perform heat conduction between the first cooling liquid in the liquid cooling apparatus and the second cooling liquid in the cooling apparatus, the control unit 802 is further configured to detect a first flow rate of the first cooling liquid, determine a target temperature-change rate of battery pack *a,* determine a target heat-conduction rate corresponding to the target temperature-change rate, determine a second flow rate of the second cooling liquid according to the target heat-conduction rate and the first flow rate, and control the second cooling liquid in the cooling apparatus to flow at the second flow rate to reach the target heat-conduction rate with the first cooling liquid.

Optionally, the battery heat-dissipation processing apparatus 800 is further configured to determine a target auxiliary heat-dissipation device corresponding to battery pack *a* when the target difference is greater than a set value, determine a target operating parameter of the target auxiliary heat-dissipation device, and control the target auxiliary heat-dissipation device to operate according to the target operating parameter, to perform auxiliary heat dissipation on battery pack *a.*

Optionally, in terms of determining the target auxiliary heat-dissipation device corresponding to battery pack *a* when the target difference is greater than the set value, the battery heat-dissipation processing apparatus 800 is further configured to: determine a target heat-dissipation rate corresponding to the target difference; determine a pre-configured heat-dissipation rate of each of *p* auxiliary heat-dissipation devices to obtain *p* heat-dissipation rates, where *p* is a positive integer; select *q* heat-dissipation rates from the *p* heat-dissipation rates, where a sum of the *q* heat-dissipation rates is greater than the target heat-dissipation rate, and *q* is a positive integer less than or equal to *p*; determine auxiliary heat-dissipation devices corresponding to the *q* heat-dissipation rates as target auxiliary heat-dissipation devices.

Optionally, in terms of closing the target liquid-inlet solenoid valve of battery pack *a* when the immersion degree of battery pack *a* exceeds the preset degree, the operating unit is further configured to detect a target pressure-change rate in battery pack *a,* determine a target valve-control parameter corresponding to the target pressure-change rate for the target liquid-inlet solenoid valve, control to close the target liquid-inlet solenoid valve according to the target valve-control parameter.

It may be understood that in embodiments, the functions of each program module of the battery heat-dissipation processing apparatus 800 can be specifically implemented according to the methods in the foregoing method embodiments. For specific implementation, reference can be made to related illustrations of the foregoing method embodiments, which will not be repeated herein.

A computer storage medium is further provided in embodiments of the disclosure. The computer storage medium is configured to store a computer program for electronic data interchange (EDI), where the computer program causes a computer to execute part or all of the operations in any one of the methods described in the foregoing method embodiments. The above computer includes an electronic device.

A computer program product is further provided in embodiments of the disclosure. The above computer program product includes a non-transitory computer-readable storage medium storing a computer program, where the above computer program is operable with a computer to execute part or all of operations in any one of the methods described in the foregoing method embodiments. The computer program product may be a software installation package. The above computer includes an electronic device.

It may be noted that, for the sake of simplicity, the foregoing method embodiments are described as a series of action combinations. However, it will be appreciated by those skilled in the art that the disclosure is not limited by the sequence of actions described. According to the disclosure, some operations may be performed in other orders or simultaneously. In addition, it will be appreciated by those skilled in the art that the embodiments described in the specification are preferred embodiments, and the actions and modules involved are not necessarily essential to the disclosure.

In the foregoing embodiments, the description of each embodiment has its own emphasis. For the parts not described in detail in one embodiment, reference can be made to related descriptions in other embodiments.

In several embodiments provided in the disclosure, it will be appreciated that the apparatuses disclosed may be implemented in other manners. For example, the above apparatus embodiments are merely illustrative, e.g., the division of units is only a division of logical functions, and other manners of division may be available in practice, e.g., multiple units or assemblies may be combined or may be integrated into another system, or some features may be ignored or skipped. In other respects, the coupling or direct coupling or communication connection as illustrated or discussed may be an indirect coupling or communication connection through some interfaces, apparatuses, or units, and may be electrical, or otherwise.

The units illustrated as separated parts may or may not be physically separated. Components displayed as units may or may not be physical units, and may reside at one location or may be distributed to multiple networked units. Part or all of the units may be selectively adopted according to practical needs to achieve desired objectives of the solutions of the embodiments.

In addition, various functional units described in various embodiments of the disclosure may be integrated into one processing unit or may be present as a number of physically separated units, and two or more units may be integrated into one. The above integrated units may be implemented either in the form of hardware or in the form of software functional units.

If the above integrated units are implemented as software functional units and sold or used as standalone products, they may be stored in a computer-readable storage medium. Based on such an understanding, the essential technical solution, or the portion that contributes to the prior art, or part or all of the technical solution of the disclosure may be embodied as software products. The computer software products can be stored in a memory and may include multiple instructions that, when executed, can cause a computing device (e.g., a personal computer, a server, or a network device, etc.) to execute part or all of operations of the methods described in various embodiments of the disclosure. The above memory may include various kinds of media that can store program codes, such as a universal serial bus (USB) flash disk, a read-only memory (ROM), a random access memory (RAM), a mobile hard drive, a magnetic disk, or an optical disk.

Embodiments of the disclosure are described in detail in the above. Principles and embodiments of the disclosure are elaborated with specific embodiments herein. The illustration above is only used to help understanding of methods and core ideas of the disclosure. In summary, this specification may not be understood as limitation on the disclosure.

## Claims

1. A battery heat-dissipation processing method applied to a liquid cooling system, wherein the liquid cooling system comprises a liquid cooling apparatus, an air pump, a box body, a condenser pipe, and a cooling apparatus, the box body comprises *P* battery packs, *P* being a positive integer, the condenser pipe is disposed above the box body, each of the *P* battery packs has one liquid outlet and one liquid inlet, the one liquid outlet and the one liquid inlet are both connected to the condenser pipe, the one liquid inlet corresponds to one liquid-inlet solenoid valve, the one liquid outlet corresponds to one liquid-outlet solenoid valve, the one liquid outlet is connected to the condenser pipe and the liquid cooling apparatus, the one liquid inlet is connected to the liquid cooling apparatus through the air pump, the cooling apparatus is connected to the liquid cooling apparatus, the liquid cooling apparatus is configured to store a first cooling liquid, the cooling apparatus is configured to store a second cooling liquid, and the method comprises:
in response to a temperature of battery pack *a* being greater than a first temperature threshold, determining (S201) a target difference between the temperature and the first temperature threshold, determining an opening parameter of a target liquid-inlet solenoid valve of battery pack *a* according to the target difference, and opening the target liquid-inlet solenoid valve of battery pack *a* according to the opening parameter, wherein battery pack *a* is any one of the *P* battery packs, and the target liquid-inlet solenoid valve is the liquid-inlet solenoid valve corresponding to the liquid inlet of battery pack *a*;
controlling (S202) the liquid cooling apparatus to deliver to battery pack *a* the first cooling liquid through the air pump via a target liquid inlet of battery pack *a* to immerse battery pack *a,* and closing the target liquid-inlet solenoid valve in response to an immersion degree of battery pack *a* exceeding a preset degree, wherein the target liquid inlet is the liquid inlet of battery pack *a*;
cycling (S203) the first cooling liquid through the condenser pipe to dissipate heat for battery pack *a* with the first cooling liquid, wherein the first cooling liquid changes from a liquid state into a gaseous state after heat absorption, a gaseous cooling liquid enters the condenser pipe, and the gaseous cooling liquid changes into the liquid state through heat dissipation in the condenser pipe and falls back into battery pack *a* to form a condensing loop;
in response to a current heat-dissipation rate of battery pack *a* being lower than a preset heat-dissipation rate, determining (S204) a target heat-dissipation rate difference between the preset heat-dissipation rate and the current heat-dissipation rate, determining a target discharge rate of the first cooling liquid according to the target heat-dissipation rate difference, and discharging the first cooling liquid in battery pack *a* into the liquid cooling apparatus through a target liquid outlet of battery pack *a* according to the target discharge rate, wherein the target liquid outlet is the liquid outlet of battery pack *a*;
controlling (S205) the liquid cooling apparatus to perform heat conduction between the first cooling liquid in the liquid cooling apparatus and the second cooling liquid in the cooling apparatus to implement heat dissipation of the first cooling liquid, and delivering, through the target liquid inlet of battery pack *a,* the first cooling liquid that is subject to heat dissipation to battery pack *a* to dissipate heat for battery pack *a*; and
in response to the temperature of battery pack *a* being lower than a second temperature threshold, opening (S206) a target liquid-outlet solenoid valve of battery pack *a* according to an operation situation of the condensing loop and the target liquid-inlet solenoid valve of battery pack *a* according to an operation situation of the heat conduction, and then discharging from battery pack *a* the first cooling liquid in battery pack *a* through the air pump, wherein the first temperature threshold is greater than the second temperature threshold, and the target liquid-outlet solenoid valve is the liquid-outlet solenoid valve corresponding to the target liquid outlet of battery pack *a.*

2. The method of claim 1, wherein opening the target liquid-outlet solenoid valve of battery pack *a* according to the operation situation of the condensing loop and the target liquid-inlet solenoid valve of battery pack *a* according to the operation situation of the heat conduction comprises:
determining a target fallback rate for the condensing loop;
determining a target conduction rate for the heat conduction;
determining a first control parameter corresponding to the target fallback rate;
determining a second control parameter corresponding to the target conduction rate;
controlling to open the target liquid-outlet solenoid valve of battery pack *a* according to the first control parameter; and
controlling to open the target liquid-inlet solenoid valve of battery pack *a* according to the second control parameter.

3. The method of claim 2, wherein determining the target fallback rate for the condensing loop comprises:
detecting (B1) a fallback flow of the first cooling liquid in the condenser pipe;
determining (B2) a reference fallback rate in the condenser pipe according to the fallback flow;
determining (B3) an internal temperature and an external temperature of the condenser pipe;
determining (B4) a first influence parameter corresponding to the internal temperature;
determining (B5) a second influence parameter corresponding to the external temperature; and
obtaining (B6) the target fallback rate by adjusting, according to the first influence parameter and the second influence parameter, the reference fallback rate.

4. The method of claim 3, further comprising:
determining a flow rate of the first cooling liquid in battery pack *a*;
determining a target ratio of the target fallback rate to the flow rate of the first cooling liquid in battery pack *a*; and
controlling the liquid cooling apparatus to perform heat conduction between the first cooling liquid in the liquid cooling apparatus and the second cooling liquid in the cooling apparatus comprises:
determining a first target heat-conduction rate according to the target ratio; and
controlling the liquid cooling apparatus to perform heat conduction between the first cooling liquid in the liquid cooling apparatus and the second cooling liquid in the cooling apparatus and according to the first target heat-conduction rate.

5. The method of any of claims 1 to 4, wherein controlling the liquid cooling apparatus to perform heat conduction between the first cooling liquid in the liquid cooling apparatus and the second cooling liquid in the cooling apparatus comprises:
detecting (51) a first flow rate of the first cooling liquid;
determining (52) a target temperature-change rate of battery pack *a*;
determining (53) a target heat-conduction rate corresponding to the target temperature-change rate;
determining (54) a second flow rate of the second cooling liquid according to the target heat-conduction rate and the first flow rate; and
controlling (55) the second cooling liquid in the cooling apparatus to flow at the second flow rate to reach the target heat-conduction rate with the first cooling liquid.

6. The method of any of claims 1 to 5, further comprising:
determining (11) a target auxiliary heat-dissipation device corresponding to battery pack *a* in response to the target difference being greater than a set value;
determining (12) a target operating parameter of the target auxiliary heat-dissipation device; and
controlling (13) the target auxiliary heat-dissipation device to operate according to the target operating parameter, to perform auxiliary heat dissipation on battery pack *a.*

7. The method of claim 6, wherein determining the target auxiliary heat-dissipation device corresponding to battery pack *a* in response to the target difference being greater than the set value comprises:
determining a target heat-dissipation rate corresponding to the target difference;
determining a pre-configured heat-dissipation rate of each of *p* auxiliary heat-dissipation devices, to obtain *p* heat-dissipation rates, wherein *p* is a positive integer;
selecting *q* heat-dissipation rates from the *p* heat-dissipation rates, wherein a sum of the *q* heat-dissipation rates is greater than the target heat-dissipation rate, and *q* is a positive integer less than or equal to *p*; and
determining auxiliary heat-dissipation devices corresponding to the *q* heat-dissipation rates as target auxiliary heat-dissipation devices.

8. The method of any of claims 1 to 7, wherein closing the target liquid-inlet solenoid valve in response to the immersion degree of battery pack *a* exceeding the preset degree comprises:
detecting a target pressure-change rate of battery pack *a*;
determining a target valve-control parameter corresponding to the target pressure-change rate for the target liquid-inlet solenoid valve; and
controlling to close the target liquid-inlet solenoid valve according to the target valve-control parameter.

9. A battery heat-dissipation processing apparatus applied to a liquid cooling system, wherein the liquid cooling system comprises a liquid cooling apparatus, an air pump, a box body, a condenser pipe, and a cooling apparatus, the box body comprises *P* battery packs, *P* being a positive integer, the condenser pipe is disposed above the box body, each of the *P* battery packs has one liquid outlet and one liquid inlet, the one liquid outlet and the one liquid inlet are both connected to the condenser pipe, the one liquid inlet corresponds to one liquid-inlet solenoid valve, the one liquid outlet corresponds to one liquid-outlet solenoid valve, the one liquid outlet is connected to the condenser pipe and the liquid cooling apparatus, the one liquid inlet is connected to the liquid cooling apparatus through the air pump, the cooling apparatus is connected to the liquid cooling apparatus, the liquid cooling apparatus is configured to store a first cooling liquid, the cooling apparatus is configured to store a second cooling liquid, and the battery heat-dissipation processing apparatus comprises an operating unit (801), a control unit (802), and a condensing unit (803), wherein
the operating unit (801) is configured to determine a target difference between a temperature of battery pack *a* and a first temperature threshold, determine an opening parameter of a target liquid-inlet solenoid valve of battery pack *a* according to the target difference, and open the target liquid-inlet solenoid valve of battery pack *a* according to the opening parameter in response to the temperature being greater than the first temperature threshold, wherein battery pack *a* is any one of the *P* battery packs, and the target liquid-inlet solenoid valve is the liquid-inlet solenoid valve corresponding to the liquid inlet of battery pack *a*;
the control unit (802) is configured to control the liquid cooling apparatus to deliver to battery pack *a* the first cooling liquid through the air pump via a target liquid inlet of battery pack *a* to immerse battery pack *a,* and close the target liquid-inlet solenoid valve in response to an immersion degree of battery pack *a* exceeding a preset degree, wherein the target liquid inlet is the liquid inlet of battery pack *a*;
the condensing unit (803) is configured to cycle the first cooling liquid through the condenser pipe to dissipate heat for battery pack *a* with the first cooling liquid, wherein the first cooling liquid changes from a liquid state into a gaseous state after heat absorption, a gaseous cooling liquid enters the condenser pipe, and the gaseous cooling liquid changes into the liquid state through heat dissipation in the condenser pipe and falls back into battery pack *a* to form a condensing loop;
the control unit (802) is further configured to determine a target heat-dissipation rate difference between a preset heat-dissipation rate and a current heat-dissipation rate of battery pack *a,* determine a target discharge rate of the first cooling liquid according to the target heat-dissipation rate difference, and discharge the first cooling liquid in battery pack *a* into the liquid cooling apparatus through a target liquid outlet of battery pack *a* according to the target discharge rate in response to the current heat-dissipation rate being lower than the preset heat-dissipation rate, wherein the target liquid outlet is the liquid outlet of battery pack *a*; control the liquid cooling apparatus to perform heat conduction between the first cooling liquid in the liquid cooling apparatus and the second cooling liquid in the cooling apparatus to implement heat dissipation of the first cooling liquid, and deliver, through the target liquid inlet of battery pack *a,* the first cooling liquid that is subject to heat dissipation to battery pack *a* to dissipate heat for battery pack *a*; and
the operating unit (801) is further configured to open a target liquid-outlet solenoid valve of battery pack *a* according to an operation situation of the condensing loop and the target liquid-inlet solenoid valve of battery pack *a* according to an operation situation of the heat conduction, and then discharge from battery pack *a* the first cooling liquid in battery pack *a* through the air pump in response to the temperature of battery pack *a* being lower than a second temperature threshold, wherein the first temperature threshold is greater than the second temperature threshold, and the target liquid-outlet solenoid valve is the liquid-outlet solenoid valve corresponding to the target liquid outlet of battery pack *a.*

10. An electronic device (700), applied to a liquid cooling system, wherein the liquid cooling system comprises a liquid cooling apparatus, an air pump, a box body, a condenser pipe, and a cooling apparatus, the box body comprises *P* battery packs, *P* being a positive integer, the condenser pipe is disposed above the box body, each of the *P* battery packs has one liquid outlet and one liquid inlet and the one liquid outlet, the one liquid inlet are both connected to the condenser pipe, the one liquid inlet corresponds to one liquid-inlet solenoid valve, the one liquid outlet corresponds to one liquid-outlet solenoid valve, the one liquid outlet is connected to the condenser pipe and the liquid cooling apparatus, the one liquid inlet is connected to the liquid cooling apparatus through the air pump, the cooling apparatus is connected to the liquid cooling apparatus, the liquid cooling apparatus is configured to store a first cooling liquid, the cooling apparatus is configured to store a second cooling liquid; wherein the electronic device (700) comprises a processor (701), a memory (703), a communication interface (702), and a computer program that is stored in the memory (703) and configured to be executed by the processor (701), wherein the processor (701) is configured to cause the liquid cooling system to execute the method of any of claims 1 to 8 when executing the computer program.

11. A non-transitory computer-readable storage medium configured to store a computer program for electronic data interchange (EDI), wherein the computer program causes the battery heat-dissipation processing apparatus of claim 9 to execute the method of any of claims 1 to 8.

## Patentansprüche

1. Batteriewärmeableitungsverfahren, das auf ein Flüssigkeitskühlsystem angewendet wird, wobei das Flüssigkeitskühlsystem eine Flüssigkeitskühleinrichtung, eine Luftpumpe, einen Kastenkörper, ein Kondensatorrohr und eine Kühleinrichtung umfasst, wobei der Kastenkörper *P* Batteriepacks umfasst, wobei *P* eine positive Ganzzahl ist, das Kondensatorrohr oberhalb des Kastenkörpers angeordnet ist, jedes der *P* Batteriepacks einen Flüssigkeitsauslass und einen Flüssigkeitseinlass aufweist, der eine Flüssigkeitsauslass und der eine Flüssigkeitseinlass beide mit dem Kondensatorrohr verbunden sind, der eine Flüssigkeitseinlass einem Flüssigkeitseinlass-Magnetventil entspricht, der eine Flüssigkeitsauslass einem Flüssigkeitsauslass-Magnetventil entspricht, der eine Flüssigkeitsauslass mit dem Kondensatorrohr und der Flüssigkeitskühleinrichtung verbunden ist, der eine Flüssigkeitseinlass über die Luftpumpe mit der Flüssigkeitskühleinrichtung verbunden ist, die Kühleinrichtung mit der Flüssigkeitskühleinrichtung verbunden ist, die Flüssigkeitskühleinrichtung zum Speichern einer ersten Kühlflüssigkeit konfiguriert ist, die Kühleinrichtung zum Speichern einer zweiten Kühlflüssigkeit konfiguriert ist, und das Verfahren Folgendes umfasst:
als Reaktion darauf, dass eine Temperatur des Batteriepacks *a* größer ist als ein erster Temperaturschwellenwert, Bestimmen (S201) einer Zieldifferenz zwischen der Temperatur und des ersten Temperaturschwellenwertes, Bestimmen eines Öffnungsparameters eines Zielflüssigkeitseinlass-Magnetventils des Batteriepacks *a* entsprechend der Zieldifferenz und Öffnen des Zielflüssigkeitseinlass-Magnetventils des Batteriepacks *a* entsprechend dem Öffnungsparameter, wobei Batteriepack *a* eines der Batteriepacks *P* ist, und das Zielflüssigkeitseinlass-Magnetventil das Flüssigkeitseinlass-Magnetventil ist, das dem Flüssigkeitseinlass von Batteriepack *a* entspricht;
Steuern (S202) der Flüssigkeitskühleinrichtung, um dem Batteriepack *a* die erste Kühlflüssigkeit durch die Luftpumpe über einen Zielflüssigkeitseinlass des Batteriepacks *a* zuzuführen, um das Batteriepack *a* einzutauchen, und Schließen des Zielflüssigkeitseinlass-Magnetventils als Reaktion auf einen Eintauchgrad des Batteriepacks *a,* der einen voreingestellten Grad überschreitet, wobei der Zielflüssigkeitseinlass der Flüssigkeitseinlass des Batteriepacks *a* ist;
Zirkulieren (S203) der ersten Kühlflüssigkeit durch das Kondensatorrohr, um Wärme für Batteriepack *a* mit der ersten Kühlflüssigkeit abzuleiten, wobei die erste Kühlflüssigkeit nach Wärmeaufnahme von einem flüssigen Zustand in einen gasförmigen Zustand übergeht, eine gasförmige Kühlflüssigkeit in das Kondensatorrohr eintritt und die gasförmige Kühlflüssigkeit durch Wärmeableitung in das Kondensatorrohr in den flüssigen Zustand übergeht und zurück in das Batteriepack *a* fällt, um einen Kondensationskreislauf zu bilden;
als Reaktion darauf, dass eine aktuelle Wärmeableitungsrate des Batteriepacks *a* niedriger als eine voreingestellte Wärmeableitungsrate ist, Bestimmen (S204) einer Zielwärmeableitungsratendifferenz zwischen der voreingestellten Wärmeableitungsrate und der aktuellen Wärmeableitungsrate, Bestimmen einer Zielabführrate der ersten Kühlflüssigkeit entsprechend der Zielwärmeableitungsratendifferenz, und Abführen der ersten Kühlflüssigkeit in Batteriepack *a* in die Flüssigkeitskühleinrichtung durch einen Zielflüssigkeitsauslass von Batteriepack *a* entsprechend der Zielabführrate, wobei der Zielflüssigkeitsauslass der Flüssigkeitsauslass von Batteriepack *a* ist;
Steuern (S205) der Flüssigkeitskühleinrichtung, um eine Wärmeleitung zwischen der ersten Kühlflüssigkeit in der Flüssigkeitskühleinrichtung und der zweiten Kühlflüssigkeit in der Kühleinrichtung durchzuführen, um eine Wärmeableitung der ersten Kühlflüssigkeit zu implementieren, und Zuführen der ersten Kühlflüssigkeit, die einer Wärmeableitung unterliegt, durch den Zielflüssigkeitseinlass von Batteriepack *a* an das Batteriepack *a,* um Wärme für das Batteriepack *a* abzuleiten; und
als Reaktion darauf, dass die Temperatur des Batteriepacks *a* niedriger ist als ein zweiter Temperaturschwellenwert, Öffnen (S206) eines Zielflüssigkeitsauslass-Magnetventils des Batteriepacks *a* entsprechend einer Betriebssituation des Kondensationskreislaufs und des Zielflüssigkeitseinlass-Magnetventils des Batteriepacks *a* entsprechend einer Betriebssituation der Wärmeleitung und dann Abführen der ersten Kühlflüssigkeit aus dem Batteriepack a durch die Luftpumpe, wobei der erste Temperaturschwellenwert größer ist als der zweite Temperaturschwellenwert und das Zielflüssigkeitsauslass-Magnetventil das dem Zielflüssigkeitsauslass des Batteriepacks *a* entsprechende Flüssigkeitsauslass-Magnetventil ist.

2. Verfahren nach Anspruch 1, wobei das Öffnen des Zielflüssigkeitsauslass-Magnetventils des Batteriepacks *a* entsprechend der Betriebssituation des Kondensationskreislaufs und des Zielflüssigkeitseinlass-Magnetventils des Batteriepacks *a* entsprechend der Betriebssituation der Wärmeleitung Folgendes umfasst:
Bestimmen einer Zielrückfallrate für den Kondensationskreislauf;
Bestimmen einer Zielleitungsrate für die Wärmeleitung;
Bestimmen eines ersten Steuerparameters, der der Zielrückfallrate entspricht;
Bestimmen eines zweiten Steuerparameters, der der Zielleitungsrate entspricht;
Steuern zum Öffnen des Zielflüssigkeitsauslass-Magnetventils des Batteriepacks *a* gemäß dem ersten Steuerparameter; und
Steuern zum Öffnen des Zielflüssigkeitseinlass-Magnetventils des Batteriepacks *a* gemäß dem zweiten Steuerparameter.

3. Verfahren nach Anspruch 2, wobei das Bestimmen der Zielrückfallrate für den Kondensationskreislauf Folgendes umfasst:
Erkennen (B1) eines Rückfallflusses der ersten Kühlflüssigkeit in dem Kondensatorrohr;
Bestimmen (B2) einer Referenzrückfallrate in dem Kondensatorrohr entsprechend dem Rückfallfluss;
Bestimmen (B3) einer Innentemperatur und einer Außentemperatur des Kondensatorrohrs;
Bestimmen (B4) eines ersten Einflussparameters entsprechend der Innentemperatur;
Bestimmen (B5) eines zweiten Einflussparameters entsprechend der Außentemperatur; und
Erhalten (B6) der Zielrückfallrate durch Anpassen, entsprechend dem ersten Einflussparameter und dem zweiten Einflussparameter, der Referenzrückfallrate.

4. Verfahren nach Anspruch 3, ferner umfassend:
Bestimmen einer Durchflussrate der ersten Kühlflüssigkeit in Batteriepack *a*;
Bestimmen eines Zielverhältnisses der Zielrückfallrate zu der Durchflussrate der ersten Kühlflüssigkeit in Batteriepack *a*; und
Steuern der Flüssigkeitskühleinrichtung zum Durchführen einer Wärmeleitung zwischen der ersten Kühlflüssigkeit in der Flüssigkeitskühleinrichtung und der zweiten Kühlflüssigkeit in der Kühleinrichtung umfasst:
Bestimmen einer ersten Zielwärmeleitungsrate gemäß dem Zielverhältnis; und
Steuern der Flüssigkühleinrichtung, um eine Wärmeleitung zwischen der ersten Kühlflüssigkeit in der Flüssigkühleinrichtung und der zweiten Kühlflüssigkeit in der Kühleinrichtung und gemäß der ersten Zielwärmeleitungsrate durchzuführen.

5. Verfahren nach einem der Ansprüche 1 bis 4, wobei das Steuern der Flüssigkeitskühleinrichtung zum Durchführen einer Wärmeleitung zwischen der ersten Kühlflüssigkeit in der Flüssigkeitskühleinrichtung und der zweiten Kühlflüssigkeit in der Kühleinrichtung Folgendes umfasst:
Erkennen (51) einer ersten Durchflussrate der ersten Kühlflüssigkeit;
Bestimmen (52) einer Zieltemperaturänderungsrate des Batteriepacks *a*;
Bestimmen (53) einer Zielwärmeleitungsrate, die der Zieltemperaturänderungsrate entspricht;
Bestimmen (54) einer zweiten Durchflussrate der zweiten Kühlflüssigkeit entsprechend der Zielwärmeleitungsrate und der ersten Durchflussrate; und
Steuern (55) der zweiten Kühlflüssigkeit in der Kühleinrichtung, um mit der zweiten Durchflussrate zu fließen, um die Zielwärmeleitungsrate mit der ersten Kühlflüssigkeit zu erreichen.

6. Verfahren nach einem der Ansprüche 1 bis 5, ferner umfassend:
Bestimmen (11) einer Zielhilfswärmeableitungsvorrichtung, die dem Batteriepack *a* entspricht, als Reaktion darauf, dass die Zieldifferenz größer ist als ein eingestellter Wert;
Bestimmen (12) eines Zielbetriebsparameters der Zielhilfswärmeableitungsvorrichtung; und
Steuern (13) der Zielhilfswärmeableitungsvorrichtung, um gemäß dem Zielbetriebsparameter zu arbeiten, um eine Hilfswärmeableitung an Batteriepack *a* durchzuführen.

7. Verfahren nach Anspruch 6, wobei das Bestimmen der dem Batteriepack *a* entsprechenden Zielhilfswärmeableitungsvorrichtung als Reaktion darauf, dass die Zieldifferenz größer ist als der eingestellte Wert, Folgendes umfasst:
Bestimmen einer Zielwärmeableitungsrate, die der Zieldifferenz entspricht;
Bestimmen einer vorkonfigurierten Wärmeableitungsrate jeder der *p* Hilfswärmeableitungsvorrichtungen, um *p* Wärmeableitungsraten zu erhalten, wobei *p* eine positive Ganzzahl ist;
Auswählen von *q* Wärmeableitungsraten aus den *p* Wärmeableitungsraten, wobei eine Summe der *q* Wärmeableitungsraten größer ist als die Zielwärmeableitungsrate und *q* eine positive Ganzzahl kleiner oder gleich *p* ist; und
Bestimmen von den *q* Wärmeableitungsraten entsprechenden Hilfswärmeableitungsvorrichtungen als Zielhilfswärmeableitungsvorrichtungen.

8. Verfahren nach einem der Ansprüche 1 bis 7, wobei das Schließen des Zielflüssigkeitseinlass-Magnetventils als Reaktion auf den Eintauchgrad des Batteriepacks *a,* der den voreingestellten Grad überschreitet, Folgendes umfasst:
Erkennen einer Zieldruckänderungsrate des Batteriepacks *a*;
Bestimmen eines Zielventilsteuerparameters, der der Zieldruckänderungsrate für das Zielflüssigkeitseinlass-Magnetventil entspricht; und
Steuern zum Schließen des Zielflüssigkeitseinlass-Magnetventils gemäß dem Zielventilsteuerparameter.

9. Batteriewärmeableitungsverarbeitungseinrichtung, die auf ein Flüssigkeitskühlsystem angewendet wird, wobei das Flüssigkeitskühlsystem eine Flüssigkeitskühleinrichtung, eine Luftpumpe, einen Kastenkörper, ein Kondensatorrohr und eine Kühleinrichtung umfasst, der Kastenkörper *P* Batteriepacks umfasst, wobei *P* eine positive Ganzzahl ist, das Kondensatorrohr oberhalb des Kastenkörpers angeordnet ist, jedes der *P* Batteriepacks einen Flüssigkeitsauslass und einen Flüssigkeitseinlass aufweist, der eine Flüssigkeitsauslass und der eine Flüssigkeitseinlass beide mit dem Kondensatorrohr verbunden sind, der eine Flüssigkeitseinlass einem Flüssigkeitseinlass-Magnetventil entspricht, der eine Flüssigkeitsauslass einem Flüssigkeitsauslass-Magnetventil entspricht, der eine Flüssigkeitsauslass mit dem Kondensatorrohr und der Flüssigkeitskühleinrichtung verbunden ist, der eine Flüssigkeitseinlass über die Luftpumpe mit der Flüssigkeitskühleinrichtung verbunden ist, die Kühleinrichtung mit der Flüssigkeitskühleinrichtung verbunden ist, die Flüssigkeitskühleinrichtung zum Speichern einer ersten Kühlflüssigkeit eingerichtet ist, die Kühleinrichtung zum Speichern einer zweiten Kühlflüssigkeit eingerichtet ist, und die Batteriewärmeableitungsverarbeitungseinrichtung eine Bedieneinheit (801), eine Steuereinheit (802) und eine Verflüssigungseinheit (803) umfasst, wobei
die Bedieneinheit (801) so konfiguriert ist, dass sie eine Zieldifferenz zwischen einer Temperatur des Batteriepacks *a* und eines ersten Temperaturschwellenwertes bestimmt, einen Öffnungsparameter eines Zielflüssigkeitseinlass-Magnetventils des Batteriepacks *a* entsprechend der Zieldifferenz bestimmt und das Zielflüssigkeitseinlass-Magnetventil des Batteriepacks *a* entsprechend dem Öffnungsparameter als Reaktion darauf öffnet, dass die Temperatur größer ist als der erste Temperaturschwellenwert, wobei Batteriepack *a* eines der Batteriepacks *P* ist, und das Zielflüssigkeitseinlass-Magnetventil das Flüssigkeitseinlass-Magnetventil ist, das dem Flüssigkeitseinlass von Batteriepack *a* entspricht;
die Steuereinheit (802) so konfiguriert ist, dass sie die Flüssigkeitskühleinrichtung steuert, um dem Batteriepack *a* die erste Kühlflüssigkeit durch die Luftpumpe über einen Zielflüssigkeitseinlass des Batteriepacks *a* zuzuführen, um das Batteriepack *a* einzutauchen, und das Zielflüssigkeitseinlass-Magnetventil als Reaktion auf einen Eintauchgrad des Batteriepacks *a* zu schließen, der einen voreingestellten Grad überschreitet, wobei der Zielflüssigkeitseinlass der Flüssigkeitseinlass des Batteriepacks *a* ist;
die Verflüssigungseinheit (803) so konfiguriert ist, dass sie die erste Kühlflüssigkeit durch das Kondensatorrohr zirkuliert, um Wärme für Batteriepack *a* mit der ersten Kühlflüssigkeit abzuleiten, wobei die erste Kühlflüssigkeit nach Wärmeaufnahme von einem flüssigen Zustand in einen gasförmigen Zustand übergeht, eine gasförmige Kühlflüssigkeit in das Kondensatorrohr eintritt, und die gasförmige Kühlflüssigkeit durch Wärmeableitung in dem Kondensatorrohr in den flüssigen Zustand übergeht und zurück in das Batteriepack *a* fällt, um einen Kondensationskreislauf zu bilden;
die Steuereinheit (802) ferner so konfiguriert ist, dass sie eine Zielwärmeableitungsratendifferenz zwischen einer voreingestellten Wärmeableitungsrate und einer aktuellen Wärmeableitungsrate des Batteriepacks *a* bestimmt, eine Zielabführrate der ersten Kühlflüssigkeit entsprechend der Zielwärmeableitungsratendifferenz bestimmt und die erste Kühlflüssigkeit in Batteriepack *a* durch einen Zielflüssigkeitsauslass von Batteriepack *a* entsprechend der Zielabführrate als Reaktion darauf, dass die aktuelle Wärmeableitungsrate niedriger ist als die voreingestellte Wärmeableitungsrate, in die Flüssigkeitskühleinrichtung abführt, wobei der Zielflüssigkeitsauslass der Flüssigkeitsauslass von Batteriepack *a* ist; die Flüssigkeitskühleinrichtung steuert, um eine Wärmeleitung zwischen der ersten Kühlflüssigkeit in der Flüssigkeitskühleinrichtung und der zweiten Kühlflüssigkeit in der Kühleinrichtung durchzuführen, um eine Wärmeableitung der ersten Kühlflüssigkeit zu implementieren, und durch den Zielflüssigkeitseinlass von Batteriepack *a* dem Batteriepack *a* die erste Kühlflüssigkeit, die einer Wärmeableitung unterliegt, zuführt, um Wärme für Batteriepack *a* abzuleiten; und
die Bedieneinheit (801) ferner so konfiguriert ist, dass sie ein Zielflüssigkeitsauslass-Magnetventil des Batteriepacks *a* entsprechend einer Betriebssituation des Kondensationskreislaufs und das Zielflüssigkeitseinlass-Magnetventil des Batteriepacks *a* entsprechend einer Betriebssituation der Wärmeleitung öffnet und dann die erste Kühlflüssigkeit in Batteriepack *a* durch die Luftpumpe als Reaktion darauf, dass die Temperatur von Batteriepack *a* niedriger als ein zweiter Temperaturschwellenwert ist, aus Batteriepack *a* abführt, wobei der erste Temperaturschwellenwert größer ist als der zweite Temperaturschwellenwert, und das Zielflüssigkeitsauslass-Magnetventil das dem Zielflüssigkeitsauslass von Batteriepack a entsprechende Magnetventil ist.

10. Elektronische Vorrichtung (700), die auf ein Flüssigkeitskühlsystem angewendet wird, wobei das Flüssigkeitskühlsystem eine Flüssigkeitskühleinrichtung, eine Luftpumpe, einen Kastenkörper, ein Kondensatorrohr und eine Kühleinrichtung umfasst, der Kastenkörper *P* Batteriepacks umfasst, wobei *P* eine positive Ganzzahl ist, das Kondensatorrohr oberhalb des Kastenkörpers angeordnet ist, jedes der *P* Batteriepacks einen Flüssigkeitsauslass und einen Flüssigkeitseinlass aufweist und der eine Flüssigkeitsauslass, der eine Flüssigkeitseinlass beide mit dem Kondensatorrohr verbunden sind, der eine Flüssigkeitseinlass einem Flüssigkeitseinlass-Magnetventil entspricht, der eine Flüssigkeitsauslass einem Flüssigkeitsauslass-Magnetventil entspricht, der eine Flüssigkeitsauslass mit dem Kondensatorrohr und der Flüssigkeitskühleinrichtung verbunden ist, der eine Flüssigkeitseinlass über die Luftpumpe mit der Flüssigkeitskühleinrichtung verbunden ist, die Kühleinrichtung mit der Flüssigkeitskühleinrichtung verbunden ist, die Flüssigkeitskühleinrichtung zum Speichern einer ersten Kühlflüssigkeit konfiguriert ist, die Kühleinrichtung zum Speichern einer zweiten Kühlflüssigkeit konfiguriert ist; wobei die elektronische Vorrichtung (700) einen Prozessor (701), einen Speicher (703), eine Kommunikationsschnittstelle (702) und ein Computerprogramm umfasst, das in dem Speicher (703) gespeichert und so konfiguriert ist, dass es von dem Prozessor (701) ausgeführt wird, wobei der Prozessor (701) so konfiguriert ist, dass er das Flüssigkeitskühlsystem dazu veranlasst, das Verfahren nach einem der Ansprüche 1 bis 8 auszuführen, wenn das Computerprogramm ausgeführt wird.

11. Nichtvorübergehendes rechnerlesbares Speichermedium, das so konfiguriert ist, dass es ein Computerprogramm für den elektronischen Datenaustausch (EDI) speichert, wobei das Computerprogramm die Batteriewärmeableitungsverarbeitungseinrichtung nach Anspruch 9 dazu veranlasst, das Verfahren nach einem der Ansprüche 1 bis 8 auszuführen.

## Revendications

1. Procédé de traitement par dissipation thermique de batterie appliqué à un système de refroidissement par liquide, dans lequel le système de refroidissement par liquide comporte un appareil de refroidissement par liquide, une pompe à air, un corps en caisson, un tuyau de condenseur et un appareil de refroidissement, le corps en caisson comporte *P* blocs-batteries, *P* étant un entier positif, le tuyau de condenseur est disposé au-dessus du corps en caisson, chacun des *P* blocs-batteries présente une sortie de liquide et une entrée de liquide, la sortie de liquide et l'entrée de liquide sont toutes deux raccordées au tuyau de condenseur, l'entrée de liquide correspond à une électrovanne d'entrée de liquide, la sortie de liquide correspond à une électrovanne de sortie de liquide, la sortie de liquide est raccordée au tuyau de condenseur et à l'appareil de refroidissement par liquide, l'entrée de liquide est raccordée à l'appareil de refroidissement par liquide par l'intermédiaire de la pompe à air, l'appareil de refroidissement est raccordé à l'appareil de refroidissement par liquide, l'appareil de refroidissement par liquide est configuré pour stocker un premier liquide de refroidissement, l'appareil de refroidissement est configuré pour stocker un deuxième liquide de refroidissement, et le procédé comporte :
en réponse au fait qu'une température d'un bloc-batterie *a* est supérieure à un premier seuil de température, la détermination (S201) d'une différence cible entre la température et le premier seuil de température, la détermination d'un paramètre d'ouverture d'une électrovanne d'entrée de liquide cible du bloc-batterie *a* selon la différence cible, et l'ouverture de l'électrovanne d'entrée de liquide cible du bloc-batterie *a* selon le paramètre d'ouverture, dans lequel le bloc-batterie *a* est l'un quelconque des *P* blocs-batteries, et l'électrovanne d'entrée de liquide cible est l'électrovanne d'entrée de liquide correspondant à l'entrée de liquide du bloc-batterie *a* ;
la commande (S202) de l'appareil de refroidissement par liquide pour distribuer au bloc-batterie *a* le premier liquide de refroidissement par l'intermédiaire de la pompe à air via une entrée de liquide cible du bloc-batterie *a* pour immerger le bloc-batterie *a,* et la fermeture de l'électrovanne d'entrée de liquide cible en réponse au fait qu'un degré d'immersion du bloc-batterie *a* dépasse un degré prédéfini, dans lequel l'entrée de liquide cible est l'entrée de liquide du bloc-batterie *a* ;
la circulation (S203) du premier liquide de refroidissement à travers le tuyau de condenseur pour dissiper la chaleur pour le bloc-batterie *a* avec le premier liquide de refroidissement, dans lequel le premier liquide de refroidissement passe d'un état liquide à un état gazeux après absorption de chaleur, un liquide de refroidissement gazeux pénètre dans le tuyau de condenseur, et le liquide de refroidissement gazeux passe à l'état liquide par dissipation thermique dans le tuyau de condenseur et retourne dans le bloc-batterie *a* pour former une boucle de condensation ;
en réponse au fait qu'un taux de dissipation thermique actuel du bloc-batterie *a* est inférieur à un taux de dissipation thermique prédéfini, la détermination (S204) d'une différence de taux de dissipation thermique cible entre le taux de dissipation thermique prédéfini et le taux de dissipation thermique actuel, la détermination d'un taux d'évacuation cible du premier liquide de refroidissement selon la différence de taux de dissipation thermique cible, et l'évacuation du premier liquide de refroidissement présent dans le bloc-batterie *a* dans l'appareil de refroidissement par liquide à travers une sortie de liquide cible du bloc-batterie *a* selon le taux d'évacuation cible, dans lequel la sortie de liquide cible est la sortie de liquide du bloc-batterie *a* ;
la commande (S205) de l'appareil de refroidissement par liquide pour réaliser une conduction thermique entre le premier liquide de refroidissement dans l'appareil de refroidissement par liquide et le deuxième liquide de refroidissement dans l'appareil de refroidissement pour mettre en œuvre une dissipation thermique du premier liquide de refroidissement, et la distribution, à travers l'entrée de liquide cible du bloc-batterie *a,* du premier liquide de refroidissement qui est soumis à une dissipation thermique au bloc-batterie *a* pour dissiper la chaleur pour le bloc-batterie *a* ; et
en réponse au fait que la température du bloc-batterie *a* est inférieure à un deuxième seuil de température, l'ouverture (S206) d'une électrovanne de sortie de liquide cible du bloc-batterie *a* selon une situation de fonctionnement de la boucle de condensation et de l'électrovanne d'entrée de liquide cible du bloc-batterie *a* selon une situation de fonctionnement de la conduction thermique, puis l'évacuation depuis le bloc-batterie *a* du premier liquide de refroidissement présent dans le bloc-batterie *a* à travers la pompe à air, dans lequel le premier seuil de température est supérieur au deuxième seuil de température, et l'électrovanne de sortie de liquide cible est l'électrovanne de sortie de liquide correspondant à la sortie de liquide cible du bloc-batterie *a.*

2. Procédé selon la revendication 1, dans lequel l'ouverture de l'électrovanne de sortie de liquide cible du bloc-batterie *a* selon la situation de fonctionnement de la boucle de condensation et de l'électrovanne d'entrée de liquide cible du bloc-batterie *a* selon la situation de fonctionnement de la conduction thermique comporte :
la détermination d'un taux de retour cible pour la boucle de condensation ;
la détermination d'un taux de conduction cible pour la conduction thermique ;
la détermination d'un premier paramètre de commande correspondant au taux de retour cible ;
la détermination d'un deuxième paramètre de commande correspondant au taux de conduction cible ;
la commande de l'ouverture de l'électrovanne de sortie de liquide cible du bloc-batterie *a* selon le premier paramètre de commande ; et
la commande de l'ouverture de l'électrovanne d'entrée de liquide cible du bloc-batterie *a* selon le deuxième paramètre de commande.

3. Procédé selon la revendication 2, dans lequel la détermination du taux de retour cible pour la boucle de condensation comporte :
la détection (B1) d'un écoulement de retour du premier liquide de refroidissement dans le tuyau de condenseur ;
la détermination (B2) d'un taux de retour de référence dans le tuyau de condenseur selon l'écoulement de retour ;
la détermination (B3) d'une température interne et d'une température externe du tuyau de condenseur ;
la détermination (B4) d'un premier paramètre d'influence correspondant à la température interne ;
la détermination (B5) d'un deuxième paramètre d'influence correspondant à la température externe ;
et
l'obtention (B6) du taux de retour cible par ajustement, selon le premier paramètre d'influence et le deuxième paramètre d'influence, du taux de retour de référence.

4. Procédé selon la revendication 3, comportant en outre :
la détermination d'un débit du premier liquide de refroidissement dans le bloc-batterie *a* ;
la détermination d'un rapport cible entre le taux de retour cible et le débit du premier liquide de refroidissement dans le bloc-batterie *a* ; et
la commande de l'appareil de refroidissement par liquide pour réaliser une conduction thermique entre le premier liquide de refroidissement dans l'appareil de refroidissement par liquide et le deuxième liquide de refroidissement dans l'appareil de refroidissement comporte :
la détermination d'un premier taux de conduction thermique cible selon le rapport cible ; et
la commande de l'appareil de refroidissement par liquide pour réaliser une conduction thermique entre le premier liquide de refroidissement dans l'appareil de refroidissement par liquide et le deuxième liquide de refroidissement dans l'appareil de refroidissement et selon le premier taux de conduction thermique cible.

5. Procédé selon l'une quelconque des revendications 1 à 4, dans lequel la commande de l'appareil de refroidissement par liquide pour réaliser une conduction thermique entre le premier liquide de refroidissement dans l'appareil de refroidissement par liquide et le deuxième liquide de refroidissement dans l'appareil de refroidissement comporte :
la détection (51) d'un premier débit du premier liquide de refroidissement ;
la détermination (52) d'un taux de changement de température cible du bloc-batterie *a* ;
la détermination (53) d'un taux de conduction thermique cible correspondant au taux de changement de température cible ;
la détermination (54) d'un deuxième débit du deuxième liquide de refroidissement selon le débit de conduction thermique cible et le premier débit ; et
la commande (55) du deuxième liquide de refroidissement dans l'appareil de refroidissement pour qu'il s'écoule au deuxième débit afin d'atteindre le débit de conduction thermique cible avec le premier liquide de refroidissement.

6. Procédé selon l'une quelconque des revendications 1 à 5, comportant en outre :
la détermination (11) d'un dispositif de dissipation thermique auxiliaire cible correspondant au bloc-batterie *a* en réponse au fait que la différence cible est supérieure à une valeur définie ;
la détermination (12) d'un paramètre de fonctionnement cible du dispositif de dissipation thermique auxiliaire cible ; et
la commande (13) du dispositif de dissipation thermique auxiliaire cible pour qu'il fonctionne selon le paramètre de fonctionnement cible, afin de réaliser une dissipation thermique auxiliaire sur le bloc-batterie *a.*

7. Procédé selon la revendication 6, dans lequel la détermination du dispositif de dissipation thermique auxiliaire cible correspondant au bloc-batterie *a* en réponse au fait que la différence cible est supérieure à la valeur définie comporte :
la détermination d'un taux de dissipation thermique cible correspondant à la différence cible ;
la détermination d'un taux de dissipation thermique préconfiguré de chacun des *p* dispositifs de dissipation thermique auxiliaires, pour obtenir *p* taux de dissipation thermique, dans lequel *p* est un entier positif ;
la sélection de *q* taux de dissipation thermique parmi les *p* taux de dissipation thermique, dans lequel une somme des *q* taux de dissipation thermique est supérieure au taux de dissipation thermique cible, et *q* est un entier positif inférieur ou égal à *p* ; et
la détermination de dispositifs de dissipation thermique auxiliaires correspondant aux *q* taux de dissipation thermique en tant que dispositifs de dissipation thermique auxiliaires cibles.

8. Procédé selon l'une quelconque des revendications 1 à 7, dans lequel la fermeture de l'électrovanne d'entrée de liquide cible en réponse au fait que le degré d'immersion du bloc-batterie *a* dépasse le degré prédéfini comporte :
la détection d'un taux de changement de pression cible du bloc-batterie *a* ;
la détermination d'un paramètre de commande de vanne cible correspondant au taux de changement de pression cible pour l'électrovanne d'entrée de liquide cible ; et
la commande de la fermeture de l'électrovanne d'entrée de liquide cible selon le paramètre de commande de vanne cible.

9. Appareil de traitement par dissipation thermique de batterie appliqué à un système de refroidissement par liquide, dans lequel le système de refroidissement par liquide comporte un appareil de refroidissement par liquide, une pompe à air, un corps en caisson, un tuyau de condenseur et un appareil de refroidissement, le corps en caisson comporte *P* blocs-batteries, *P* étant un entier positif, le tuyau de condenseur est disposé au-dessus du corps en caisson, chacun des *P* blocs-batteries présente une sortie de liquide et une entrée de liquide, la sortie de liquide et l'entrée de liquide sont toutes deux raccordées au tuyau de condenseur, l'entrée de liquide correspond à une électrovanne d'entrée de liquide, la sortie de liquide correspond à une électrovanne de sortie de liquide, la sortie de liquide est raccordée au tuyau de condenseur et à l'appareil de refroidissement par liquide, l'entrée de liquide est raccordée à l'appareil de refroidissement par liquide par l'intermédiaire de la pompe à air, l'appareil de refroidissement est raccordé à l'appareil de refroidissement par liquide, l'appareil de refroidissement par liquide est configuré pour stocker un premier liquide de refroidissement, l'appareil de refroidissement est configuré pour stocker un deuxième liquide de refroidissement, et l'appareil de traitement par dissipation thermique de batterie comporte une unité d'exploitation (801), une unité de commande (802) et une unité de condensation (803), dans lequel
l'unité d'exploitation (801) est configurée pour déterminer une différence cible entre une température du bloc-batterie *a* et un premier seuil de température, déterminer un paramètre d'ouverture d'une électrovanne d'entrée de liquide cible du bloc-batterie *a* selon la différence cible, et ouvrir l'électrovanne d'entrée de liquide cible du bloc-batterie *a* selon le paramètre d'ouverture en réponse au fait que la température est supérieure au premier seuil de température, dans lequel le bloc-batterie *a* est l'un quelconque des *P* blocs-batteries, et l'électrovanne d'entrée de liquide cible est l'électrovanne d'entrée de liquide correspondant à l'entrée de liquide du bloc-batterie *a* ;
l'unité de commande (802) est configurée pour commander l'appareil de refroidissement par liquide pour distribuer au bloc-batterie *a* le premier liquide de refroidissement à travers la pompe à air via une entrée de liquide cible du bloc-batterie *a* pour immerger le bloc-batterie *a,* et fermer l'électrovanne d'entrée de liquide cible en réponse au fait qu'un degré d'immersion du bloc-batterie *a* dépasse un degré prédéfini, dans lequel l'entrée de liquide cible est l'entrée de liquide du bloc-batterie *a ;*
l'unité de condensation (803) est configurée pour faire circuler le premier liquide de refroidissement à travers le tuyau de condenseur pour dissiper la chaleur pour le bloc-batterie *a* avec le premier liquide de refroidissement, dans lequel le premier liquide de refroidissement passe d'un état liquide à un état gazeux après absorption de chaleur, un liquide de refroidissement gazeux pénètre dans le tuyau de condenseur, et le liquide de refroidissement gazeux passe à l'état liquide par dissipation thermique dans le tuyau de condenseur et retourne dans le bloc-batterie *a* pour former une boucle de condensation ;
l'unité de commande (802) est en outre configurée pour déterminer une différence de taux de dissipation thermique cible entre un taux de dissipation thermique prédéfini et un taux de dissipation thermique actuel du bloc-batterie *a,* déterminer un taux d'évacuation cible du premier liquide de refroidissement selon la différence de taux de dissipation thermique cible, et évacuer le premier liquide de refroidissement présent dans le bloc-batterie *a* dans l'appareil de refroidissement par liquide à travers une sortie de liquide cible du bloc-batterie *a* selon le taux d'évacuation cible en réponse au fait que le taux de dissipation thermique actuel est inférieur au taux de dissipation thermique prédéfini, dans lequel la sortie de liquide cible est la sortie de liquide du bloc-batterie *a* ; commander l'appareil de refroidissement par liquide pour réaliser une conduction thermique entre le premier liquide de refroidissement dans l'appareil de refroidissement par liquide et le deuxième liquide de refroidissement dans l'appareil de refroidissement pour mettre en œuvre une dissipation thermique du premier liquide de refroidissement, et distribuer, à travers l'entrée de liquide cible du bloc-batterie *a,* le premier liquide de refroidissement qui est soumis à une dissipation thermique au bloc-batterie *a* pour dissiper la chaleur pour le bloc-batterie *a* ; et
l'unité d'exploitation (801) est en outre configurée pour ouvrir une électrovanne de sortie de liquide cible du bloc-batterie *a* selon une situation de fonctionnement de la boucle de condensation et l'électrovanne d'entrée de liquide cible du bloc-batterie *a* selon une situation de fonctionnement de la conduction thermique, puis évacuer depuis le bloc-batterie *a* le premier liquide de refroidissement présent dans le bloc-batterie *a* par l'intermédiaire de la pompe à air en réponse au fait que la température du bloc-batterie *a* est inférieure à un deuxième seuil de température, dans lequel le premier seuil de température est supérieur au deuxième seuil de température, et l'électrovanne de sortie de liquide cible est l'électrovanne de sortie de liquide correspondant à la sortie de liquide cible du bloc-batterie *a.*

10. Dispositif électronique (700), appliqué à un système de refroidissement par liquide, dans lequel le système de refroidissement par liquide comporte un appareil de refroidissement par liquide, une pompe à air, un corps en caisson, un tuyau de condenseur et un appareil de refroidissement, le corps en caisson comporte P blocs-batteries, P étant un entier positif, le tuyau de condenseur est disposé au-dessus du corps en caisson, chacun des P blocs-batteries présente une sortie de liquide et une entrée de liquide, et la sortie de liquide et l'entrée de liquide sont toutes deux raccordées au tuyau de condenseur, l'entrée de liquide correspond à une électrovanne d'entrée de liquide, la sortie de liquide correspond à une électrovanne de sortie de liquide, la sortie de liquide est raccordée au tuyau de condenseur et à l'appareil de refroidissement par liquide, l'entrée de liquide est raccordée à l'appareil de refroidissement par liquide par l'intermédiaire de la pompe à air, l'appareil de refroidissement est raccordé à l'appareil de refroidissement par liquide, l'appareil de refroidissement par liquide est configuré pour stocker un premier liquide de refroidissement, l'appareil de refroidissement est configuré pour stocker un deuxième liquide de refroidissement ; dans lequel le dispositif électronique (700) comporte un processeur (701), une mémoire (703), une interface de communication (702) et un programme informatique qui est stocké dans la mémoire (703) et configuré pour être exécuté par le processeur (701), dans lequel le processeur (701) est configuré pour amener le système de refroidissement par liquide à exécuter le procédé selon l'une quelconque des revendications 1 à 8 lors de l'exécution du programme informatique.

11. Support de stockage non transitoire lisible par ordinateur configuré pour stocker un programme informatique pour un échange électronique de données (EDI), dans lequel le programme informatique amène l'appareil de traitement par dissipation thermique de batterie selon la revendication 9 à exécuter le procédé selon l'une quelconque des revendications 1 à 8.
